# EUROPEAN PATENT APPLICATION

(11) **EP 4 788 114 A2**
(43) Date of publication of application: **05.08.2026**
(21) Application number: 26156176.5
(22) Date of filing: 03.02.2026
(51) Int. Cl.: H10P 72/00, H10P 72/30, H10P 72/76

(54) **SUBSTRATE PROCESSING APPARATUS**

(30) Priority: 04.02.2025 JP 2025017109
(71) Applicant: SCREEN Holdings Co., Ltd., Kyoto-shi, Kyoto 602-8585 (JP)
(72) Inventor: IWASAKI, Akihiro, Kyoto, 602-8585 (JP); TAJI, Takumi, Kyoto, 602-8585 (JP)
(74) Representative: Kilian Kilian & Partner mbB

(57) **Abstract**

A substrate processing apparatus including: a batch processing block (7) for performing a batch process; a first orientation conversion mechanism (71) capable of converting substrates having been subjected to the batch process, from a vertical orientation to a horizontal orientation; a standby bath (55) where the substrates having been converted into the horizontal orientation are kept on standby; a lifting mechanism for performing an exposing operation of bringing one of the substrates kept on standby in the standby bath (55), the one being one substrate at a time, to a space above the standby bath (55); a center robot capable of carrying the substrates in the space above the standby bath (55) to outside; and a single-wafer processing block (8) including a single-wafer processing chamber (48) where the single-wafer process is performed to the substrates in the horizontal orientation, and the center robot (CR) carries the substrates from the space above the standby bath (55) into the single-wafer processing chamber (48).

## Description

### Background of the invention

The present invention relates to a substrate processing apparatus for applying a predetermined process to various types of substrates, such as a semiconductor substrate, a substrate for a flat panel display (FPD) including a liquid crystal display and an organic electroluminescence (EL) display device, a glass substrate for a photomask, and a substrate for an optical disc.

### Description of the Related Art

The apparatuses according to JP 2024-47292 A and JP 2024-106669 A each include a batch module and a single-wafer module. The batch module is configured to perform a predetermined process on a plurality of substrates all at once. The single-wafer module is configured to perform a predetermined process on each of the substrates, one by one. The apparatus according to JP 2024-47292 A is configured to, after causing the batch module to perform a batch process on substrates, cause the single-wafer module to perform a single-wafer process on the substrates.

The apparatus according to JP 2024-47292 A includes an orientation conversion device that converts the orientation of substrates from the vertical orientation to the horizontal orientation and that is provided to an end of the batch module, and a horizontal substrate transport device that transports the substrates from the batch module to the single-wafer module, in the horizontal orientation.

The apparatus according to JP 2024-106669 A is provided with an orientation conversion device and a horizontal transport device that are similar to those described above, in the base end of the batch module.

### <List of documents>

JP 2024-47292 A
JP 2024-106669 A

A conventional substrate processing apparatus requires such a horizontal transport device between the batch module and the single-wafer module. As the horizontal transport device is provided, the size of the device is increased by that amount.

The present invention has been made in view of such circumstances, and an object of the present invention is to provide a substrate processing apparatus having a smaller footprint.

### Summary of the invention

In order to address the challenge described above, the present invention has the following configuration.

In other words, a substrate processing apparatus according to the present invention is a substrate processing apparatus that performs a batch process for processing a plurality of substrates all at once, and a single-wafer process for processing one of the substrates at a time, continuously, the substrate processing apparatus including:
a batch processing block that performs the batch process;
a first orientation conversion mechanism capable of converting the plurality of substrates having been subjected to the batch process, from a vertical orientation to a horizontal orientation;
a standby bath where the plurality of substrates having been converted into the horizontal orientation are kept on standby;
a lifting mechanism that performs an exposing operation of bringing one of the substrates kept on standby in the standby bath, the one being one substrate at a time, to a space above the standby bath;
a center robot capable of carrying the substrates in the space above the standby bath to outside; and
a single-wafer processing block including a single-wafer processing chamber where the single-wafer process is performed to the substrates in the horizontal orientation,
in which the center robot carries the substrates having been moved out of the space above the standby bath into the single-wafer processing chamber.

[Operations and Effects] With the configuration described above, the center robot transfers the substrate from the space above the standby bath into the single-wafer processing chamber. Therefore, the present invention does not need to be provided with a device for transporting the substrates in the horizontal orientation, as in the conventional configuration, except for the center robot. According to the present invention, it is possible to provide a substrate processing apparatus that has a smaller footprint, by eliminating the need for a substrate transport device for transporting the substrates in the horizontal orientation.

Furthermore, in the substrate processing apparatus described above, preferably,
the batch processing block includes: treatment baths arranged along a predetermined direction and allowing a plurality of vertically oriented substrates to be immersed in a treatment liquid; and
a batch transport robot capable of transporting the substrates having been subjected to treatment in the treatment bath, toward the standby bath in the predetermined direction, and
the center robot is at a reference position that is spaced apart from the standby bath in a horizontal direction that is orthogonal to the predetermined direction.

[Operations and Effects] With the configuration described above, the batch processing block includes treatment baths arranged along a predetermined direction and allowing a plurality of vertically oriented substrates to be immersed in a treatment liquid; and a batch transport robot capable of transporting the substrates having been subjected to treatment in the treatment bath, toward the standby bath in the predetermined direction, and the center robot is at a reference position that is spaced apart from the standby bath in a horizontal direction that is orthogonal to the predetermined direction. With this configuration, it is not necessary to separate the single-wafer processing block and the batch processing block in the predetermined direction, so that the length of the substrate processing apparatus in the predetermined direction can be reduced.

In the substrate processing apparatus described above, preferably
the single-wafer processing block includes a plurality of the single-wafer processing chambers that are arranged in the predetermined direction,
each of the single-wafer processing chambers has a predetermined length in the predetermined direction, and
the center robot is enabled to move along the predetermined direction by a distance equal to or more than the predetermined length from the reference position.

[Operations and Effects] With the configuration described above, the single-wafer processing block includes a plurality of the single-wafer processing chambers that are arranged in the predetermined direction; each of the single-wafer processing chambers has a predetermined length in the predetermined direction; and the center robot is enabled to move in the predetermined direction by a distance equal to or more than the predetermined length from the reference position. With this configuration, the number of the single-wafer processing chambers in the substrate processing block can be increased easily.

Furthermore, the substrate processing apparatus described above preferably further includes, between a first single-wafer processing chamber and a second single-wafer processing chamber that are spaced apart from each other in the predetermined direction, a wet robot that carries a substrate on which a puddle is formed in the first single-wafer processing chamber to outside, and transports the substrate into the second single-wafer processing chamber.

[Operations and Effects] With the configuration described above, between a first single-wafer processing chamber and a second single-wafer processing chamber that are spaced apart from each other in the predetermined direction, a wet robot that carries a substrate W on which a puddle is formed in the first single-wafer processing chamber to outside, and transports the substrate into the second single-wafer processing chamber is provided. With this configuration, the wet robot and the center robot can operate independently from each other without interfering with each other.

Furthermore, in the substrate processing apparatus described above, preferably,
the first single-wafer processing chamber is at a position closer to the reference position than the second single-wafer processing chamber is.

[Operations and Effects] With the configuration described above, the first single-wafer processing chamber is at a position closer to the reference position than the second single-wafer processing chamber is. With this configuration, it is possible to minimize the distance by which the substrate is moved when the center robot moves the wet substrate from the space above the standby bath into the first single-wafer processing chamber. As a result, it is possible to provide a substrate processing apparatus capable of maintaining the wet state of a substrate reliably while the center robot transfers a substrate.

Furthermore, in the substrate processing apparatus described above, preferably,
the second single-wafer processing chamber performs a drying process using a supercritical fluid.

[Operations and Effects] With the configuration described above, the second single-wafer processing chamber performs a drying process using a supercritical fluid. As described above, the present invention is suitable for a substrate processing apparatus that uses a supercritical fluid.

The substrate processing apparatus preferably includes:
a backup bath that receives the substrates transported toward the standby bath by the batch transport robot; and
an auxiliary robot that transports the substrates between the backup bath and the standby bath in the horizontal direction.

[Operations and Effects] The configuration described above is provided with a backup bath that receives the substrates having been transported toward the standby bath by the batch transport robot; and an auxiliary robot that transports the substrates between the backup bath and the standby bath in the horizontal direction. With this configuration, the substrates having been subjected to the batch process can be transported reliably to the standby bath.

Furthermore, the substrate processing apparatus described above preferably includes:
a carrier robot that picks up substrates from a carrier where the substrates in the horizontal orientation are stored as a stack, all at once;
a second orientation conversion mechanism that converts the substrates in the horizontal orientation, the substrates having been picked up by the carrier robot, into the vertical orientation; and
a substrate placing unit on which the center robot stacks and places the substrates having been subjected to the single-wafer process, in which
the batch transport robot is enabled to transport the substrates in the vertical orientation, the substrates being substrates having the orientation converted by the second orientation conversion mechanism, and
the carrier robot is enabled to pick up the substrates in the horizontal orientation, the substrates being stacked on the substrate placing unit, and to store the substrates in the carrier, all at once.

[Operations and Effects] The configuration described above is provided with a carrier robot that picks up substrates from a carrier where the substrates in the horizontal orientation are stored as a stack, all at once. The carrier robot is enabled to pick up the substrates in the horizontal orientation, the substrates being stacked on the substrate placing unit, and to store the substrates in the carrier, all at once. With this configuration, because the unprocessed substrates and the processed substrates can be transported using the same robot, a substrate processing apparatus with a simple device configuration and a smaller footprint can be provided.

Furthermore, the substrate processing apparatus described above preferably includes
a retainer shelf on which the carrier is placed, in which
the standby bath is at a position in the predetermined direction from the retainer shelf, and
the standby bath is at a position in a direction opposite to the predetermined direction from the batch processing block.

[Operations and Effects] With the configuration described above, the retainer shelf on which the carrier is placed is provided; the standby bath is at a position in a predetermined direction from the retainer shelf; and the standby bath is at a position in a direction opposite to the predetermined direction from the batch processing block. With this configuration, because it is possible to position the standby bath at the base end of the batch processing block, it is possible to provide a substrate processing apparatus having a smaller footprint.

Furthermore, in the substrate processing apparatus described above, preferably:
the single-wafer processing chamber performs a substrate drying process; and
the center robot includes a wet hand for carrying a substrate in the space above the standby bath into the single-wafer processing chamber, and a dry hand for carrying a substrate having been dried, out of the single-wafer processing chamber.

[Operations and Effects] With the configuration described above, the single-wafer processing chamber performs a substrate drying process, and the center robot includes a wet hand for carrying a substrate in the space above the standby bath into the single-wafer processing chamber, and a dry hand for carrying a substrate having been dried, out of the single-wafer processing chamber. With this configuration, the substrate subjected to the drying process can be carried out of the single-wafer processing chamber, reliably.

Furthermore, the substrate processing apparatus described above preferably includes:
a first passage that is adjacent to the batch processing block from the horizontal direction, and that is accessible to the center robot; and
a first room that extends from the first passage in a direction separating from the single-wafer processing block.

[Operations and Effects] The configuration described above is provided with a first passage that is adjacent to the batch processing block from the horizontal direction, and that is accessible to the center robot; and a first room that extends from the first passage in a direction separating from the single-wafer processing block. With this configuration, it is possible to provide a substrate processing apparatus capable of performing maintenance of the center robot or the like, easily.

Furthermore, the substrate processing apparatus described above preferably further includes:
a second passage that is adjacent to the carrier robot and that extends in the horizontal direction, and
a second room that extends from the second passage in a direction approaching the standby bath.

[Operations and Effects] With the configuration described above, a second passage that is adjacent to the carrier robot and that extends in the horizontal direction, and a second room that extends from the second passage in a direction approaching the standby bath are provided. With this configuration, it is possible to provide a substrate processing apparatus capable of performing maintenance of the center robot or the like, easily.

According to the present invention, it is possible to provide a substrate processing apparatus having a smaller footprint.

### Brief of description of the drawings

FIG. 1 is a plan view for explaining a configuration of the entire substrate processing apparatus according to an embodiment;
FIG. 2 is a perspective view illustrating a transfer block according to the embodiment;
FIG. 3 is a plan view for explaining a configuration of a backup bath of the substrate processing apparatus according to the embodiment;
FIG. 4 is a cross-sectional view for explaining transportation of substrates in the substrate processing apparatus according to the embodiment;
FIG. 5 is a cross-sectional view for explaining the transportation of the substrates in the substrate processing apparatus according to the embodiment;
FIG. 6 is a cross-sectional view for explaining the transportation of the substrates in the substrate processing apparatus according to the embodiment;
FIG. 7 is a cross-sectional view for explaining the transportation of the substrates in the substrate processing apparatus according to the embodiment;
FIG. 8 is a cross-sectional view for explaining the transportation of the substrates in the substrate processing apparatus according to the embodiment;
FIG. 9 is a cross-sectional view for explaining a substrate orientation conversion in the substrate processing apparatus according to the embodiment;
FIG. 10 is a cross-sectional view for explaining the substrate orientation conversion in the substrate processing apparatus according to the embodiment;
FIG. 11 is a cross-sectional view for explaining a substrate lifting operation in the substrate processing apparatus according to the embodiment;
FIG. 12 is a cross-sectional view for explaining the transportation of the substrates in the substrate processing apparatus according to the embodiment;
FIG. 13 is a cross-sectional view for explaining the transportation of the substrates in the substrate processing apparatus according to the embodiment;
FIG. 14 is a cross-sectional view for explaining the transportation of the substrates in the substrate processing apparatus according to the embodiment;
FIG. 15 is a cross-sectional view for explaining the transportation of the substrates in the substrate processing apparatus according to the embodiment;
FIG. 16 is a cross-sectional view for explaining the transportation of the substrates in the substrate processing apparatus according to the embodiment;
FIG. 17 is a cross-sectional view for explaining the substrate orientation conversion in the substrate processing apparatus according to the embodiment;
FIG. 18 is a cross-sectional view for explaining the substrate orientation conversion in the substrate processing apparatus according to the embodiment;
FIG. 19 is a cross-sectional view for explaining a substrate lifting operation in the substrate processing apparatus according to the embodiment;
FIG. 20 is a cross-sectional view for explaining how a substrate is picked up by a center robot in the substrate processing apparatus according to the embodiment;
FIG. 21 is a cross-sectional view for explaining how the substrate is picked up by the center robot in the substrate processing apparatus according to the embodiment;
FIG. 22 is a cross-sectional view for explaining how the substrate is picked up by the center robot in the substrate processing apparatus according to the embodiment;
FIG. 23 is a cross-sectional view for explaining how the substrate is picked up by the center robot in the substrate processing apparatus according to the embodiment;
FIG. 24 is a cross-sectional view for explaining how the substrate is picked up by the center robot in the substrate processing apparatus according to the embodiment;
FIG. 25 is a cross-sectional view for explaining how the substrate is picked up by the center robot in the substrate processing apparatus according to the embodiment;
FIG. 26 is a side view for explaining a configuration of the center robot according to the embodiment;
FIG. 27 is a plan view for explaining the configuration of the center robot according to the embodiment;
FIG. 28 is a plan view for explaining the configuration of the center robot according to the embodiment;
FIG. 29 is a rear view for explaining a pass box according to the embodiment;
FIG. 30 is a side view for explaining the pass box according to the embodiment;
FIG. 31 is a plan view for explaining a maintenance area according to the embodiment;
FIG. 32 is a flowchart for explaining the movement of substrates according to the embodiment;
FIG. 33 is a plan view for explaining the movement of substrates according to the embodiment;
FIG. 34 is a plan view for explaining the movement of substrates according to the embodiment;
FIG. 35 is a plan view for explaining a configuration according to one modification of the present invention;
FIG. 36 is a plan view for explaining a movement of substrates according to one modification of the present invention; and
FIG. 37 is a plan view for explaining a configuration according to one modification of the present invention.

### Description of the preferred embodiments

An embodiment of the present invention will now be explained with reference to drawings. A substrate processing apparatus according to the present invention performs a batch process of processing a plurality of substrates all at once, and a single-wafer process of processing one of the substrates at a time, continuously, and includes a batch processing block related to the batch process and a single-wafer processing block related to the single-wafer process.

### Embodiment

### <1. Overall Configuration>

The substrate processing apparatus according to this example is divided into a plurality of blocks. In other words, the substrate processing apparatus according to this example includes a stocker block 3, a transfer block 5, an orientation conversion block 6, a batch processing block 7, a single-wafer transport block 4, and a single-wafer processing block 8.

The stocker block 3 will now be explained briefly. The stocker block 3 manages carriers C each storing therein a plurality of substrates W, and is configured to send substrates W not processed yet housed in the carrier C to the transfer block 5, and to store substrates W having been processed in a carrier C.

A carrier C is a container storing therein substrates W that are in horizontal orientations and arranged in the vertical direction. One example of the carrier C is a sealed front opening unified pod (FOUP). In the present invention, an open container may also be used as the carrier C. The carrier C can house twenty-five substrates that are arranged at a full pitch (1 cm interval), for example.

The transfer block 5 will now be explained briefly. The transfer block 5 is configured to receive a plurality of substrates W from the stocker block 3 all at once, and to convert the orientations of the substrates W from the horizontal orientation to the vertical orientation. In the transfer block 5, two sets of twenty-five substrates arranged at the full pitches are combined into a lot in which fifty substrates W are arranged at half pitches (5 mm intervals).

The batch processing block 7 is configured to subject the substrates W included in a lot to a chemical liquid treatment.

The orientation conversion block 6 is configured to convert the substrates W included in a lot from the vertical orientation to the horizontal orientation, after the lot is subjected to the chemical liquid treatment.

The single-wafer transport block 4 receives a substrate W in the horizontal orientation from the orientation conversion block 6, and transports the substrate W into the single-wafer processing block 8, using a center robot CR.

The single-wafer processing block 8 includes a plurality of a single-wafer processing chambers 48 for a performing predetermined process, such as a drying process, to a substrate W.

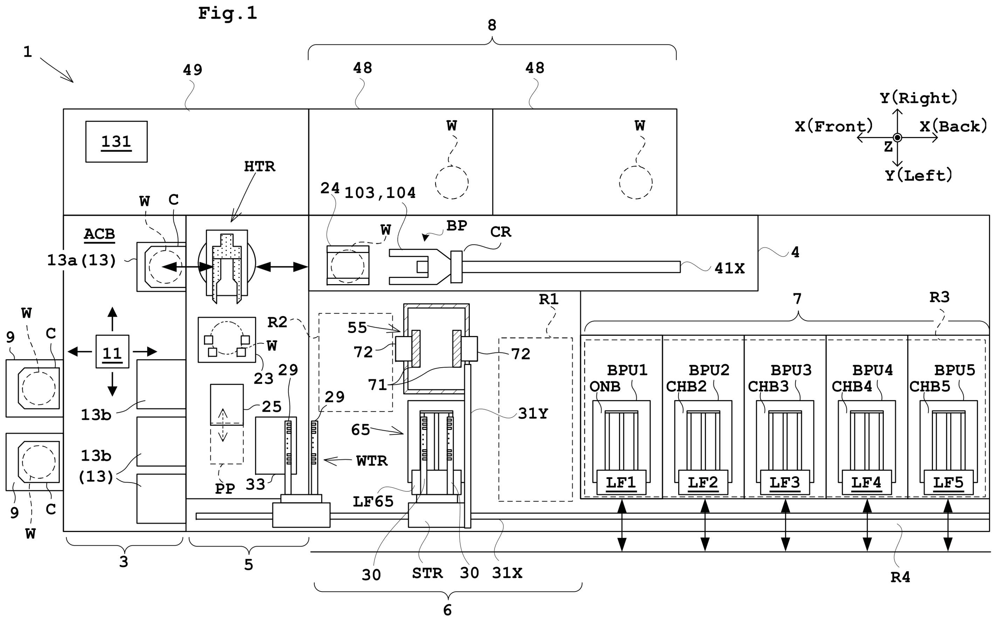

As it can be seen by referring to FIG. 1, the stocker block 3, the transfer block 5, the orientation conversion block 6, and the batch processing block 7 are arranged in a row, in the order listed herein. The direction in which the stocker block 3, the transfer block 5, the orientation conversion block 6, and the batch processing block 7 are arranged corresponds to a predetermined direction according to the present invention. In FIG. 1, the predetermined direction is illustrated as an X direction.

The orientation conversion block 6, the single-wafer transport block 4, and the single-wafer processing block 8 are arranged in a row, in the order listed herein. The direction in which the orientation conversion block 6, the single-wafer transport block 4, and the single-wafer processing block 8 are arranged corresponds to the horizontal direction according to the present invention. In FIG. 1, the horizontal direction is illustrated as a Y direction. The predetermined direction and the horizontal direction are orthogonal to each other.

The X direction is defined as a front-back direction in FIG. 1. In other words, the direction from the transfer block 5 toward the stocker block 3 corresponds to the forward direction, and the direction opposite thereto is the backward direction. Similarly, the Y direction is defined as a left-right direction in FIG. 1. In other words, the direction from the orientation conversion block 6 toward the single-wafer transport block 4 is the rightward direction, and the direction opposite thereto is the leftward direction. The Z direction is defined as a vertical direction in FIG. 1.

Each of the blocks will now be explained in detail.

### <2. Stocker Block>

The stocker block 3 includes a first loading port 9 that is an entrance via which a carrier C storing therein a plurality of horizontally oriented substrates W arranged along the vertical direction at predetermined intervals is carried into the block. The first loading port 9 is a configuration projecting from the outer wall of the stocker block 3 that extends in the width direction (Y direction).

An internal structure of the stocker block 3 will now be described. The stocker block 3 includes a transport storage area ACB where the carriers C are stocked and managed. The transport storage area ACB is provided with a carrier transport mechanism 11 for transporting a carrier C, and a shelf 13 on which a carrier C is placed. In the stocker block 3, one or more carriers C can be stocked.

The stocker block 3 has a plurality of shelves 13 on which the carriers C are placed. The shelves 13 are provided to a partitioning wall between the stocker block 3 and the transfer block 5. The shelves 13 include a stocker shelf 13b merely for placing a carrier C temporarily, and a carrier retainer shelf 13a from which a substrate is to be taken out by being accessed by a handling robot HTR, which is provided to the transfer block 5.

The carrier retainer shelf 13a has a configuration on which a carrier C can be placed, with the carrier C storing therein a plurality of horizontally oriented substrates, with a predetermined interval therebetween in the vertical direction. The carrier retainer shelf 13a is a configuration for placing a carrier C from which a substrate W is to be taken out. In this embodiment, one carrier retainer shelf 13a is provided, but it is also possible to provide a plurality of the carrier retainer shelves 13a. The carrier transport mechanism 11 picks up a carrier C storing therein unprocessed substrates W from the first loading port 9, and places the carrier C on the carrier retainer shelf 13a from which the substrates are to be taken out. At this time, the carrier transport mechanism 11 can also place the carrier C temporarily on the stocker shelf 13b before placing the carrier C on the carrier retainer shelf 13a. The stocker block 3 has one or more carrier retainer shelves 13a.

### <3. Batch Processing Device: Transfer Block>

The transfer block 5 is positioned adjacently to the carrier retainer shelf 13a. The transfer block 5 is disposed adjacently on the rear side of the stocker block 3. The transfer block 5 includes the handling robot HTR capable of accessing a carrier C placed on the carrier retainer shelf 13a from which a substrate is taken out, an HVC orientation converting unit 23 that changes the orientation of a plurality of substrates W, from the horizontal orientation to the vertical orientation, all at once, and a pusher mechanism 25. The HVC orientation converting unit 23 converts the orientation of a plurality of substrates W from the horizontal orientation to the vertical orientation, all at once. In the transfer block 5, a substrate passing position PP is set as a position at which the plurality of substrates W are passed to a substrate transport mechanism WTR, which is provided to a batch transport region R4.

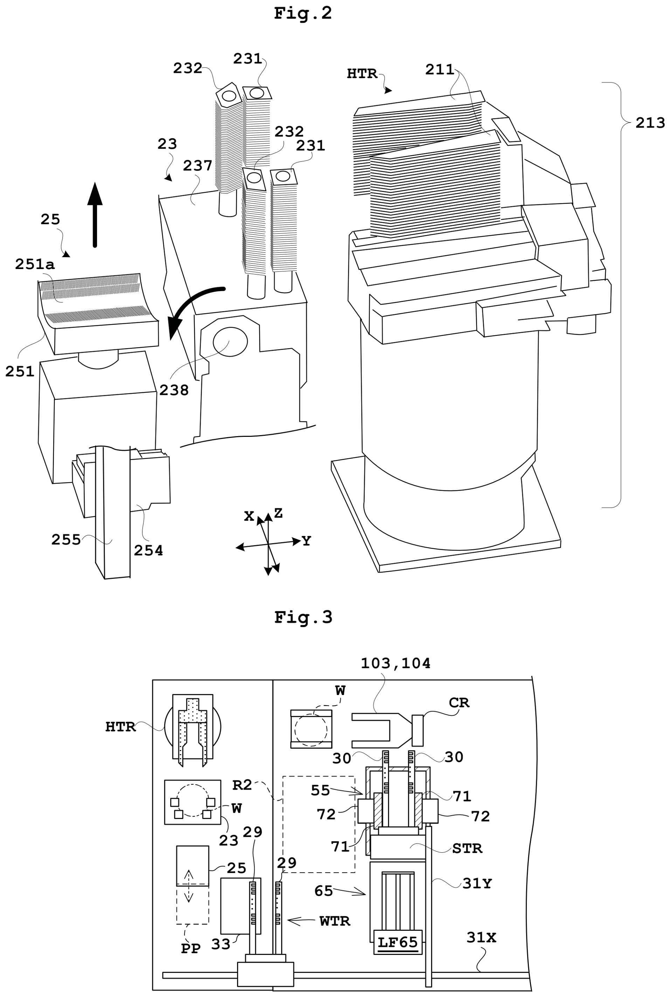

As illustrated in FIG. 2, the handling robot HTR, the HVC orientation converting unit 23, and the pusher mechanism 25 are arranged along the Y direction, in the order listed herein. The handling robot HTR includes a hand 211 capable of gripping a horizontally oriented substrate W. The hand 211 is capable of gripping one substrate W. On the handling robot HTR, a plurality of the hands 211 are arranged along the vertical direction. By causing the hands 211 to grip the substrates, respectively, the handling robot HTR can transport the plurality of substrates W at once. An actuating support mechanism 213 is a mechanism of the handling robot HTR, and is a configuration for rotating the hands 211 about the vertical axis, for moving the hands 211 upward and downward, for advancing and retracting the hands 211 in the front-back direction X, and for moving the hands 211 laterally in the left-right direction Y.

The handling robot HTR has twenty five hands 211. With these, the handling robot HTR transports twenty-five substrates stored in a carrier C, all at once.

The HVC orientation converting unit 23 is a configuration for converting the orientation of the substrates W having been taken out from the carrier C by the handling robot HTR, from the horizontal orientation to the vertical orientation. The HVC orientation converting unit 23 includes a pair of placing rods 231 and a pair of clamping rods 232, both of the pairs extending in the vertical direction (Z direction). A support base 237 has a support surface extending along an XY plane, and supporting the placing rods 231 and the clamping rods 232. A rotation driving mechanism 238 is a configuration for rotating the entire support base 237, including the placing rods 231 and the clamping rods 232, by 90°. As a result of this rotation, the placing rods 231 and the clamping rods 232 come to extend in the left-right direction (Y direction).

The pusher mechanism 25 includes a pusher 251 capable of aligning the vertically oriented substrates W in the horizontal direction. The pusher 251 is a half-pipe pusher having a shape that follows the bottom curve of the substrates W. A U-shaped groove 251a forming the half pipe of the pusher 251 extends in the left-right direction Y, in the initial state. The pusher 251 in the initial state can receive the substrates W from the HVC orientation converting unit 23.

A pusher shifting mechanism 254 can cause the pusher 251 in the initial state to reciprocate along the left-right direction Y. The pusher shifting mechanism 254 can move the pusher 251 closer to the HVC orientation converting unit 23, or move the pusher 251 closer to the substrate transport mechanism WTR.

A pusher lifting mechanism 255 can lift the pusher 251 at an initial position to a midair position. The pusher lifting mechanism 255 can also bring the pusher 251 at the midair position back to the initial position.

Transportation of the horizontally oriented substrates W, having been picked up from the carrier C by the handling robot HTR, onto the pusher 251 will now be described. To begin with, the handling robot HTR directs the hands 211 forward, and picks up an array of horizontally oriented substrates from the carrier C, all at once. The handling robot HTR then rotates the hands 211 about a vertically extending rotation axis, and directs the hands 211 toward the HVC orientation converting unit 23, as illustrated in FIG. 2. In FIG. 2, the substrates W held by the hands 211 are not illustrated.

The hands 211 then pass the substrate array onto the HVC orientation converting unit 23. At this time, the substrates W are held by the pair of placing rods 231.

The HVC orientation converting unit 23 having received the substrate array then converts the orientation of the substrates W included in the substrate array from the horizontal orientation to the vertical orientation, by causing the rotation driving mechanism 238 to operate, as indicated by the arrow in FIG. 2. As a result, the horizontally oriented substrates W having been arranged along the vertical direction are converted into the vertical orientation, in a manner arranged along the left-right direction Y (horizontal direction). At this time, the substrates W are released from the pair of placing rods 231, and become supported on the pair of clamping rods 232.

Prior to this rotating operation of the HVC orientation converting unit 23, the pusher mechanism 25 moves the pusher 251 downward, as illustrated in FIG. 2, and waits for the arrival of the substrate array. The pusher mechanism 25 then raises the pusher 251 toward the substrates W supported by the clamping rods 232, as indicated by the arrow in FIG. 2. The substrates W are then pushed up by the pusher 251, separate from the clamping rods 232, and are eventually held only by the pusher 251. In this manner, the pusher mechanism 25 receives the substrates W from the HVC orientation converting unit 23.

By repeating this process of receiving the substrate array twice, the pusher mechanism 25 can form a lot including fifty substrates arranged along the horizontal direction. One lot includes substrates W corresponding to two carriers C, and the substrates W in the lot are arranged at a half pitch (5 mm) of the pitch of the substrates W in the carrier C. Furthermore, between these first and the second substrate array receiving operation, the substrate processing apparatus according to the present invention may also perform an additional operation of rotating the pusher 251 by 180° about a vertical axis.

A substrate array support 33 is a configuration enabled to temporarily stock a substrate array of dry substrates. When there is a congestion of the substrate arrays in the subsequent chemical liquid treatment, the substrate transport mechanism WTR can keep a substrate array before the chemical liquid treatment standby on the substrate array support 33.

### <4. Batch Processing Block>

As illustrated in FIG. 1, the batch processing block 7 is positioned adjacently to the transfer block 5. In the batch processing block 7, a lot described above is subjected to a batch process. The batch processing block 7 includes a batch processing region R3 and a batch transport region R4 that are arranged along the width direction (Y direction). Each of these regions extends in the front-back direction (X direction). More specifically, the batch processing region R3 is positioned inside the batch processing block 7. The batch transport region R4 is positioned adjacently to the batch processing region R3, and is positioned on the leftmost side of the batch processing block 7.

### <5. Batch Processing Block: Batch Processing Region>

The batch processing region R3 in the batch processing block 7 is a rectangular region extending in the front-back direction (X direction). One end (front side) of the batch processing region R3 is positioned adjacently to the orientation conversion block 6. The other end of the batch processing region R3 extends in a direction separating from the transfer block 5 and the orientation conversion block 6 (toward the rear side). To transport a substrate array from the batch processing block 7 to the orientation conversion block 6, the substrate transport mechanism WTR is used.

The substrate transport mechanism WTR transports a plurality of substrates W in the vertical orientation, all at once, between the transfer block 5, each of the batch processing units BPU1 to BPU5, and a backup bath 65 in the orientation conversion block 6. The batch transport region R4, which is a region where the substrate transport mechanism WTR is allowed to move, extends in the Y direction along the left end of the orientation conversion block 6.

The substrate transport mechanism WTR can transport the substrates W processed in the batch processing unit BPU toward a standby bath 55, to be described later, in the X direction. The substrate transport mechanism WTR corresponds to a batch transport robot according to the present invention.

In the batch processing block 7, the batch processing units BPU each allowing a plurality of substrates W in the vertical orientation to be immersed in a treatment liquid are arranged along the X direction. The batch processing units BPU correspond to a treatment bath according to the present invention.

The batch processing region R3 mainly includes a batch processing unit where a batch process is carried out. Specifically, the batch processing region R3 has a plurality of batch processing units BPU1 to BPU5 each allowing a plurality of substrates W to be immersed all at once, and that are arranged along the direction in which the batch processing region R3 extends. In each of the batch processing units BPU1 to BPU5, a plurality of vertically oriented substrates W are immersed, all at once. The layout of the batch processing units BPU1 to BPU5 will now be described specifically. The first batch processing unit BPU1 is positioned adjacently on the rear side of the orientation conversion block 6. The second batch processing unit BPU2 is positioned adjacently on the rear side of the first batch processing unit BPU1. The third batch processing unit BPU3 is positioned adjacently on the rear side of the second batch processing unit BPU2. The fourth batch processing unit BPU4 is positioned adjacently on the rear side of the third batch processing unit BPU3. The fifth batch processing unit BPU5 is positioned adjacently on the rear side of the fourth batch processing unit BPU4. In this manner, the first batch processing unit BPU1, the second batch processing unit BPU2, the third batch processing unit BPU3, the fourth batch processing unit BPU4, and the fifth batch processing unit BPU5 are arranged in the order listed herein, along the direction separating from the orientation conversion block 6.

The batch treatment bath is a liquid bath for holding chemical liquid or pure water. The chemical liquid may be an acidic aqueous solution, and is a phosphoric acid aqueous solution, for example. In the description herein, the chemical liquid and pure water are collectively referred to as a treatment liquid. The batch treatment baths for holding a chemical liquid will be referred to as batch chemical liquid treatment baths CHB2 to CHB5, and the batch treatment bath for holding the pure water will be referred to as batch rinsing treatment bath ONB.

Specifically, the second batch processing unit BPU2 includes the batch chemical liquid treatment bath CHB2 that subjects the substrate array to a chemical liquid treatment all at once, and a lifter LF2 that moves a substrate array up and down between a substrate passing position and a chemical liquid treatment position. The substrate passing position is a position set to a space above the batch chemical liquid treatment bath CHB2, the space being accessible by the substrate transport mechanism WTR, and the chemical liquid treatment position is a position set in the bath of the batch chemical liquid treatment bath CHB2 where the substrate array can be immersed in the chemical liquid. The batch chemical liquid treatment bath CHB2 subjects a substrate array to an acid treatment. The acid treatment may be a phosphoric acid treatment, but may be a treatment using another acid. In the phosphoric acid treatment, the plurality of substrates W forming a substrate array are subjected to an etching treatment. In the etching treatment, for example, nitride films on the surfaces of the substrates W are chemically etched.

The batch chemical liquid treatment bath CHB2 stores an acid solution such as a phosphoric acid solution. The batch chemical liquid treatment bath CHB2 is provided with the lifter LF2 for moving a substrate array up and down. The lifter LF2 moves up and down in the vertical direction (Z direction). Specifically, the lifter LF2 moves up and down between the chemical liquid treatment position corresponding to a position inside the batch chemical liquid treatment bath CHB2 and the passing position corresponding to a position above the batch chemical liquid treatment bath CHB2. The lifter LF2 holds a substrate array including vertically oriented substrates W. The lifter LF2 passes the substrate array to the substrate transport mechanism WTR at the passing position. When the lifter LF2 holding a substrate array is lowered from the passing position to the treatment position, the entire area of the substrates W sinks below the liquid surface of the chemical liquid. When the lifter LF2 rises from the treatment position to the passing position while holding the substrate array, the entire area of the substrates W is brought above the liquid surface of the chemical liquid. The lifter LF2 is enabled to immerse a plurality of vertical oriented substrates, having been subjected to the orientation conversion of the HVC orientation converting unit 23, in the batch treatment bath, all at once. At this time, the lifter LF2 is lowered from the passing position to the treatment position.

The third batch processing unit BPU3 specifically includes the batch chemical liquid treatment bath CHB3, and a lifter LF3 that moves a substrate array up and down between the substrate passing position and the chemical liquid treatment position. The batch chemical liquid treatment bath CHB3 has the same configuration as the batch chemical liquid treatment bath CHB2 described above. That is, the batch chemical liquid treatment bath CHB3 stores therein the chemical liquid described above, and is provided with the lifter LF3. The batch chemical liquid treatment bath CHB3 subjects a substrate array to the same treatment as that of the batch chemical liquid treatment bath CHB2. The batch processing block 7 according to this example includes a plurality of treatment baths enabled for the same chemical liquid treatment. This is because the phosphoric acid treatment takes more time than other types of treatments. The phosphoric acid treatment requires a long time (e.g., 60 minutes). Therefore, in the apparatus according to this example, the acid treatment can be carried out in parallel using a plurality of batch chemical liquid treatment baths.

The fourth batch processing unit BPU4 and the fifth batch processing unit BPU5 have the same configurations as the second batch processing unit BPU2 and the third batch processing unit BPU3. In other words, the fourth batch processing unit BPU4 includes the batch chemical liquid treatment bath CHB4, and a lifter LF4 that moves a substrate array up and down between the substrate passing position and the chemical liquid treatment position. Similarly, the fifth batch processing unit BPU5 includes the batch chemical liquid treatment bath CHB5, and a lifter LF5 that moves a substrate array up and down between the substrate passing position and the chemical liquid treatment position. Therefore, the substrate array is subjected to acid treatment in any one of the batch chemical liquid treatment baths CHB2 to CHB5. By carrying out the chemical liquid treatment in parallel using four treatment units in the manner described above, the apparatus can achieve a higher throughput.

The first batch processing unit BPU1 specifically includes the batch rinsing treatment bath ONB where rinsing liquid is stored, and a lifter LF1 that moves a substrate array up and down between the substrate passing position and a rinsing position. The substrate passing position is a position set above the batch rinsing treatment bath ONB accessible by the substrate transport mechanism WTR, and the rinsing position is a position set inside the batch rinsing treatment bath ONB where the substrate array can be immersed in the rinsing liquid. The batch rinsing treatment bath ONB has a configuration similar to that of the batch chemical liquid treatment bath CHB2 described above. In other words, the batch rinsing treatment bath ONB stores the rinsing liquid and is provided with the lifter LF1. Unlike other treatment baths, however, the batch rinsing treatment bath ONB stores pure water, and is provided for the purpose of cleaning the chemical liquid attached to the plurality of substrates W. The batch rinsing treatment bath ONB ends the cleaning treatment when the specific electrical resistance of the pure water inside the bath rises to a predetermined level.

As described above, the batch rinsing treatment bath ONB according to this embodiment is positioned closer to the orientation conversion block 6 than the batch chemical liquid treatment baths CHB2 to CHB5. With this configuration, the mechanisms forming the orientation conversion block 6 and the batch chemical liquid treatment baths CHB2 to CHB5 are kept separated from each other as far as possible, so that the orientation conversion block 6 is not adversely affected by the acid such as phosphoric acid. Furthermore, by arranging the orientation conversion block 6 and the batch rinsing treatment bath ONB close to each other, the substrate array for which the rinsing treatment has been finished is transported by a short distance, and carried immediately into the orientation conversion block 6. Therefore, with the configuration according to this embodiment, it is possible to finish transporting the substrates W quickly while keeping the substrate W in a wet state.

### <6. Batch Processing Block: Batch Transport Region>

The batch transport region R4 in the batch processing block 7 is a rectangular region stretching in the front-back direction (X direction). The batch transport region R4 is provided along an outer edge of the batch processing region R3, and has one end extending to the transfer block 5 and the other end extending in a direction separating from the transfer block 5. Therefore, the batch transport region R4 can also be said to be a configuration extending along the orientation conversion block 6, which is positioned between the transfer block 5 and the batch processing block 7.

The batch transport region R4 is provided with the substrate transport mechanism WTR for transporting a plurality of substrates W all at once. The substrate transport mechanism WTR transports the substrate array, all at once, between the substrate passing position PP defined in the transfer block 5, the substrate array support 33, each of the batch processing units BPU1 to BPU5, and the backup bath 65 included in the orientation conversion block 6, to be described later. The substrate transport mechanism WTR is enabled to reciprocate in the front-back direction (X direction) across the transfer block 5, the orientation conversion block 6, and the batch processing block 7. The substrate transport mechanism WTR is movable not only within the batch transport region R4 in the batch processing block 7 but also to the substrate passing position PP in the transfer block 5, the substrate array support 33, and the backup bath 65 in the orientation conversion block 6.

The substrate transport mechanism WTR includes a pair of chucks 29 for transporting a substrate array. The pair of chucks 29 can be switched between a closed state where the chucks 29 are close to each other, and an open state in which the chucks 29 are separated from each other. The chucks 29 are members that extend in the Y direction, and on which grooves for holding substrates W are provided at the full pitches (the same pitch as that of the substrate array). The pair of chucks 29 receives a plurality of substrates W forming a substrate array, by closing. The pair of chucks 29 then passes the plurality of substrates W forming the substrate array to another member (such as the lifter LF1) by opening. The substrate transport mechanism WTR passes and receives the substrate array to and from the substrate passing position PP and the substrate array support 33 in the transfer block 5, and a lifter LF65 of the backup bath 65 in the orientation conversion block 6. The substrate transport mechanism WTR also passes a substrate array to and receives a substrate array from the each of the lifters LF1 to LF5 belonging to the respective batch processing units BPU1 to BPU5 in the batch processing block 7.

A guide rail 31X for guiding the substrate transport mechanism WTR is provided in the batch transport region R4, in a manner extending along the X direction. The substrate transport mechanism WTR is enabled to move back and forth in the X direction along the guide rail 31X. Therefore, the guide rail 31X extends from the batch processing block 7, through the orientation conversion block 6, to the transfer block 5. More specifically, the guide rail 31X faces the substrate passing position PP inside the transfer block 5 from the Y direction, and faces the fifth batch processing unit BPU5 inside the batch processing block 7 from the Y direction. In addition, the guide rail 31X faces the substrate array support 33 inside the transfer block 5, the backup bath 65 inside the orientation conversion block 6, and the first batch processing unit BPU1 to the fifth batch processing unit BPU5 inside the batch processing block 7, from the Y direction.

### <7. Orientation Conversion Block>

The orientation conversion block 6 has a function of converting the orientation of the substrates W having been subjected to the batch process in the batch processing block 7, and relaying substrates W to the single-wafer transport block 4.

The orientation conversion block 6 includes a backup bath 65 in which a lot is immersed in pure water, and a standby bath 55 that receives a plurality of substrates W arranged in the Y direction, and rotates the received substrates W by 90°, all at once, in the water to change the orientation of the plurality of substrates W from the vertical orientation to the horizontal orientation. The backup bath 65 and the standby bath 55 are arranged along the Y direction. The substrate transport mechanism WTR can access the backup bath 65, and the center robot CR can access the standby bath 55.

### <8. Orientation Conversion Block: Backup Bath>

In the backup bath 65, the lot having been subjected to the batch process is immersed in pure water. The backup bath 65 has the same configuration as the first batch processing unit BPU1 included in the batch processing block 7. In other words, the backup bath 65 holds pure water, and includes the lifter LF65 that moves a lot up and down. The lifter LF65 can reciprocate between a midair position where the lot is received from the substrate transport mechanism WTR and an immersing position where the received lot is immersed in the pure water. The midair position is positioned above the backup bath 65, and the immersing position is in the backup bath 65. The midair position is set in such a manner that the entire area of the substrates W forming a lot is in the air, and the immersing position is set in such a manner that the entire area of the substrates W forming a lot is immersed in pure water.

The backup bath 65 receives a lot having been transported toward the standby bath 55 by the substrate transport mechanism WTR.

### <9. Orientation Conversion Block: Auxiliary Robot>

An auxiliary robot STR sorts the lot immersed in the backup bath 65 into first substrates W1 and second substrates W2. The auxiliary robot STR can transport twenty-five substrates W that are arranged at the full pitches, between the backup bath 65 and the standby bath 55. In the backup bath 65, fifty substrates W arranged at a half pitch are kept on standby, and the auxiliary robot STR picks up and transports twenty-five substrates, which is a half of the fifty substrates W, to the standby bath 55. The auxiliary robot STR includes a pair of chucks 30 similar to the pair of chucks 29 in the substrate transport mechanism WTR. Each of the chucks 30 has grooves provided at half-pitch intervals, in the same manner as the chuck 29, but is different from the chuck 29 in that two types of grooves are alternately arranged. In other words, the chuck 30 has deep grooves by which the substrates W cannot be gripped and shallow grooves by which the substrates W can be gripped, with the deep grooves and the shallow grooves being provided alternately at intervals of a half pitch. Therefore, when the auxiliary robot STR attempts to grip a lot in the lifter LF65, twenty-five substrates W are picked up by the shallow grooves in which substrates W can be gripped, and the remaining twenty-five substrates W cannot come into abutment against the deep grooves and remain in the lifter LF65. Because the shallow grooves in the chuck 30 are arranged at pitches that are twice the half pitches (full pitches), the auxiliary robot STR picks up twenty-five substrates W arranged at the full pitch from the lot in the lifter LF65. Because the lot includes the substrates W that are in a face-to-face arrangement, the substrates W having been picked up are arranged with the front surfaces (device surfaces) thereof facing the right side and the rear surfaces thereof facing the left side, so that the device surfaces of adjacent substrates W do not face each other. By contrast, the twenty-five substrates W remaining in the lifter LF65 without being picked up are arranged in such a manner that the front surfaces (device surfaces) thereof face the left side and the rear surfaces thereof face the right side so that the device surfaces of the adjacent substrates W do not face each other.

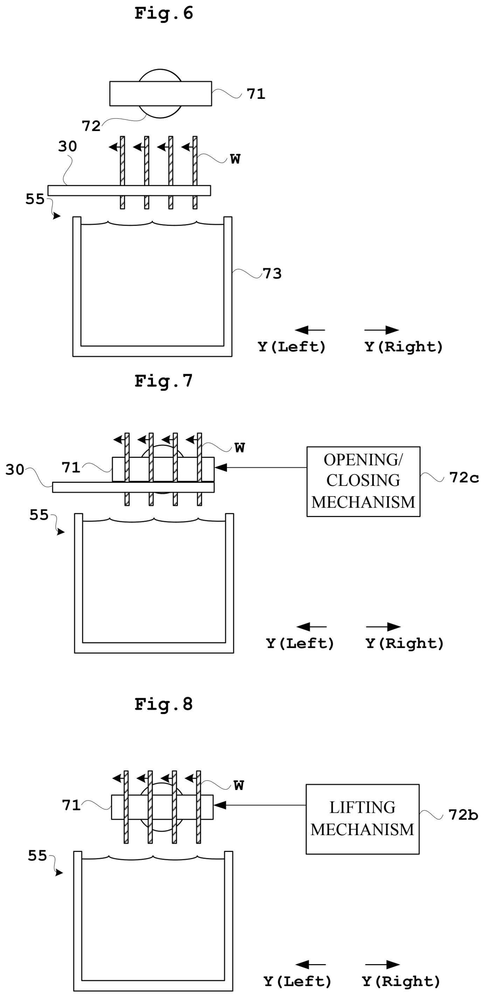

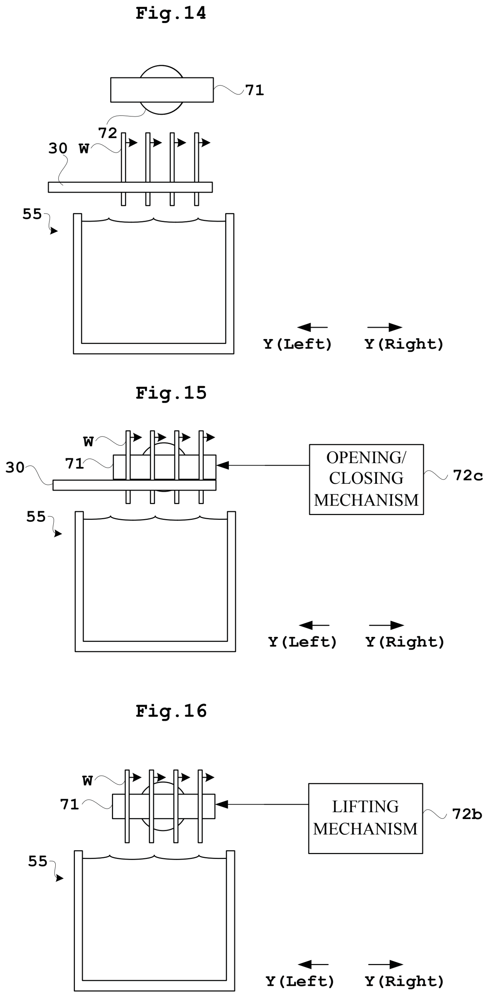

Similarly to the chuck 29 of the substrate transport mechanism WTR, the pair of chucks 30 included in the auxiliary robot STR can take two states of a closed state in which the chucks 30 are close to each other in the X direction and an open state in which the chucks 30 are separated from each other in the X direction. When the pair of chucks 30 is in the closed state, the chucks 30 are sufficiently close to each other with respect to the diameter of the substrate W, so that each of the chucks 30 comes into abutment against a lower portion of the substrate W at two points. In this manner, the substrates W are gripped by the pair of chucks 30. When the pair of chucks 30 in the closed state is opened, the chucks 30 sufficiently separate from each other with respect to the diameter of the substrates W, so that the substrates W are released from the chucks 30. Specifically, the pair of chucks 30 is brought to the open state before receiving a plurality of substrates W from the lifter LF65 at the midair position, and at the time of passing a plurality of substrates W to the reversing chucks 71, as will be described later with reference to FIGS. 7 and 15.

The orientation conversion block 6 is provided with a guide rail 31Y for guiding the auxiliary robot STR, in a manner extending along the Y direction. The auxiliary robot STR is enabled to move back and forth along the guide rail 31Y in the Y direction. The guide rail 31Y therefore extends between the backup bath 65 and the standby bath 55.

By being guided along the guide rail 31Y, the auxiliary robot STR is enabled to move back and forth between the midair position, which is a position where the lot on the lifter LF65 is passed, and the pair of reversing chucks 71, which is kept on standby above the standby bath 55, to be described later, on the right side of the midair position. As a result, the auxiliary robot STR can transport a plurality of substrates W in the Y direction between the midair position and a midair position above the standby bath. Furthermore, when the substrate transport mechanism WTR moves from the transfer block 5 to the batch processing block 7, the auxiliary robot STR can be moved to the midair position above the standby bath so as not to interfere with the substrate transport mechanism WTR (see FIG. 3).

The auxiliary robot STR transports the substrates W between the backup bath 65 and the standby bath 55 in the X direction.

### <10. Orientation Conversion Block: Standby Bath>

The standby bath 55 converts the orientation of a plurality of substrates W received from the batch processing block 7 from the vertical orientation to the horizontal orientation. The standby bath 55 converts the sorted first substrates W1 or second substrates W2 from the vertical orientation to the horizontal orientation, all at once. The standby bath 55 holds a liquid (pure water or a liquid with isopropyl alcohol (IPA) added to pure water). Above the liquid, there are a pair of reversing chucks 71 and a pair of reversing chuck supporting mechanisms 72 that hold the respective reversing chucks 71, and that raise, lower, and rotate the pair of reversing chucks 71, respectively. The reversing chucks 71 can be lowered from the substrate passing position, which is set above the liquid level of the standby bath 55 and where the substrates are passed with the auxiliary robot STR, into the liquid contained in the standby bath 55, and raised from the liquid back to the substrate passing position. The reversing chucks 71 can immerse a plurality of substrates W received from the auxiliary robot STR in the standby bath 55, and rotate the substrates W by 90° in one direction or in the opposite direction while the substrates W are immersed in the standby bath 55. By rotating the pair of reversing chucks 71, the orientation of the plurality of vertically oriented substrates W is converted into the horizontal orientation. The standby bath 55 is a configuration for keeping a plurality of substrates W having been converted into the horizontal orientation standby in the liquid. The standby bath 55 is positioned on the rear side of the carrier retainer shelf 13a and in front of the batch processing block 7.

Through the operation of the pair of reversing chuck supporting mechanisms 72, the reversing chucks 71 are enabled to go through a state change between a closed state where the plurality of substrates W can be held, and an open state in which the plurality of substrates W held thereby are released. Also through the operation of the pair of reversing chuck supporting mechanisms 72, the reversing chucks 71 can be rotated by 90° in one direction and in the opposite direction while maintaining a positional relationship with respect to each other. Through the operation of the pair of reversing chuck supporting mechanisms 72, the reversing chucks 71 can be lowered from the midair position above the standby bath 55 into the liquid contained in the standby bath 55, and raised from the liquid back to the midair position, while maintaining the positional relationship with respect to each other. The reversing chucks 71 can convert a plurality of substrates W after the batch process, from the vertical orientation into the horizontal orientation, and correspond to a first orientation conversion mechanism according to the present invention.

The reversing chuck supporting mechanisms 72 will be explained specifically. The pair of reversing chuck supporting mechanisms 72 operates synchronously, and performs a reversing operation of rotating the reversing chucks 71 by at least 180° without changing the relative position between the pair of reversing chucks 71, a lifting and lowering operation of lifting or lowering the reversing chucks 71 without changing the relative position between the pair of reversing chucks 71, and an opening and closing operation of moving the pair of reversing chucks 71 closer to each other and away from each other. The reversing chuck supporting mechanisms 72 therefore include mechanisms related to the reversing operation, the lifting and lowering operation, and the opening and closing operation, respectively. The reversing chuck supporting mechanisms 72 include a reversing mechanism 72a that performs the operation of reversing the reversing chucks 71, a lifting mechanism 72b that performs the operation of lifting and lowering the reversing chucks 71, and an opening/closing mechanism 72c that performs the operation of opening and closing the reversing chucks 71. The lifting mechanism 72b performs an exposing operation of bringing each of the substrates W kept on standby in the standby bath 55, one by one, above the standby bath 55.

Each of the reversing chucks 71 has a comb-like shape in which a plurality of V-shaped grooves 71a are provided at the full pitches, and the pair of reversing chucks 71 together holds a plurality of substrates W from both sides, by allowing the plurality of substrates W to fit into the respective V-shaped grooves. When the reversing chucks 71 are closed by the opening/closing mechanism 72c of the reversing chuck supporting mechanisms 72, each of the substrate ends comes into abutment against the deepest part of the corresponding V-shaped groove, so that, even if the reversing chucks 71 are rotated in this state, the substrate W does not slide off the reversing chucks 71. With the reversing chucks 71 opened by the opening/closing mechanism 72c of the reversing chuck supporting mechanisms 72, the reversing chucks 71 can receive a plurality of substrates W being held by the standby auxiliary robot STR that is kept standby above the standby bath 55. Although the reversing chucks 71 can also take a state between the closed state and the open state (half-opened state), this state will be described later.

The reversing mechanism 72a and the lifting mechanism 72b of the reversing chuck supporting mechanisms 72 will be described later.

### <11. Operation of Orientation Conversion Block>

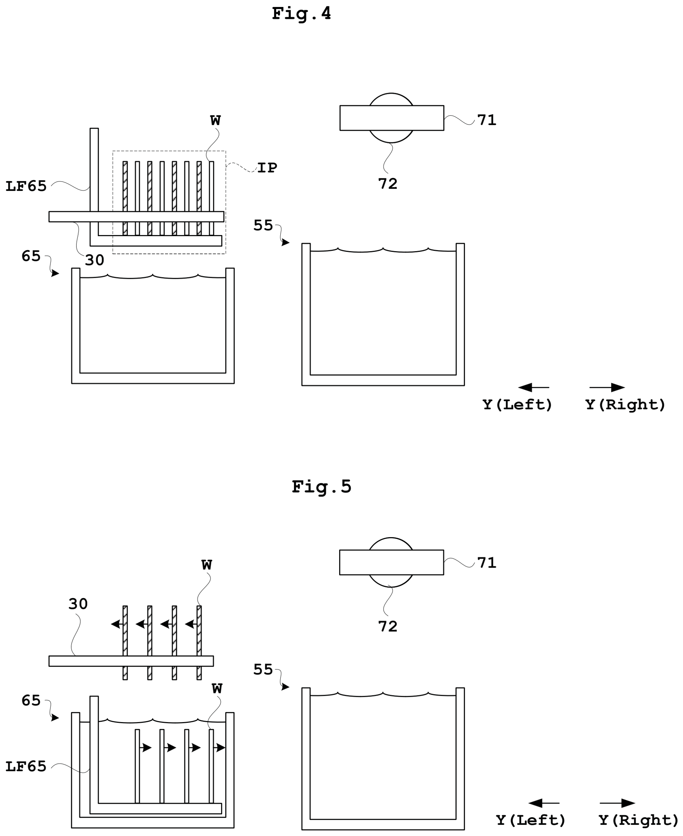

FIG. 4 illustrates a state in which the lifter LF65 is holding a plurality of substrates W at the midair position set above the backup bath 65. The substrate transport mechanism WTR is responsible for the transportation of the substrates to the midair position. The plurality of substrates W placed on the lifter LF65 are in a face-to-face arrangement, where the substrates W having the device surfaces facing rightward are arranged alternately with the substrates W having the device surfaces facing leftward.

By causing the lifter LF65 to lower from the midair position to the immersing position, it is possible, while each of the substrates W is transported one by one, to prevent the substrates W waiting to be transported from becoming dry in the orientation conversion block 6.

FIG. 4 illustrates the state in which a plurality of substrates W are being passed, all at once, from the lifter LF65 to the auxiliary robot STR, in order to transport the plurality of substrates W into the standby bath 55. At this time, the lifter LF65 supports the plurality of substrates W at the midair position, and the auxiliary robot STR moves the pair of chucks 30 to the position where the pair of chucks 30 can hold the lot, and closes the chucks 30. At this time, as mentioned earlier, the chucks 30 can grip only a half of a lot of the plurality of substrates W that are arranged at the half pitches. As a result, the substrates W held by the chucks 30 and the substrates W not held by the chucks 30 are alternately arranged in the lot.

FIG. 5 illustrates a state when the lifter LF65 is then lowered from the midair position to the immersing position. When the lifter LF65 is lowered from the state illustrated in FIG. 4, a plurality of substrates W at the full pitches, the substrates W corresponding to a half the lot, remain inside the auxiliary robot STR, and the other half of the substrates W, which are arranged at the full pitches, remaining on the lifter LF65 is returned to the backup bath 65. The plurality of substrates W remaining in the auxiliary robot STR have device surfaces facing rightward, and the plurality of substrates W held at the immersing position by the lifter LF65 have device surfaces facing leftward.

FIG. 6 illustrates a state when the auxiliary robot STR then transports the plurality of substrates W to the midair position above the standby bath 55. At this time, the pair of reversing chucks 71 is positioned above the auxiliary robot STR, with a rotation angle of 0° in the initial state. The reversing chucks 71 in the initial state extend in the horizontal direction, and are enabled to receive a plurality of substrates W in the vertical orientation.

FIG. 7 illustrates a state in which the reversing chucks 71 are then lowered to the auxiliary robot STR. This operation of the reversing chucks 71 is achieved by the lifting mechanism 72b in the reversing chuck supporting mechanisms 72. FIG. 7 illustrates the state in which the twenty-five substrates W are being passed from the chuck 30 of the auxiliary robot STR to the reversing chucks 71. In other words, the pair of reversing chucks 71 maintained in the open state is lowered to the auxiliary robot STR, and is then closed. Because the pair of reversing chucks 71 in the open state is separated from each other by a distance allowing the substrates W to pass therebetween, the reversing chucks 71 can approach the chucks 30 without coming into contact with the substrates W. The reversing chucks 71 are closed, by the operation of the opening/closing mechanism 72c of the reversing chuck supporting mechanisms 72, and grip the twenty-five substrates W. At this time, the twenty-five substrates W are gripped by the reversing chucks 71 as well as by the chucks 30. The chucks 30 are then brought to the open state, and retract in the Y direction (leftward). In this manner, the substrates W are passed from the chucks 30 to the reversing chucks 71. FIG. 8 illustrates a state after the twenty-five substrates W are passed to the reversing chucks 71. As indicated by the arrow in FIG. 8, the reversing chucks 71 are then lowered below the liquid level of the standby bath 55, and immerse twenty-five substrates W in pure water held in the standby bath 55.

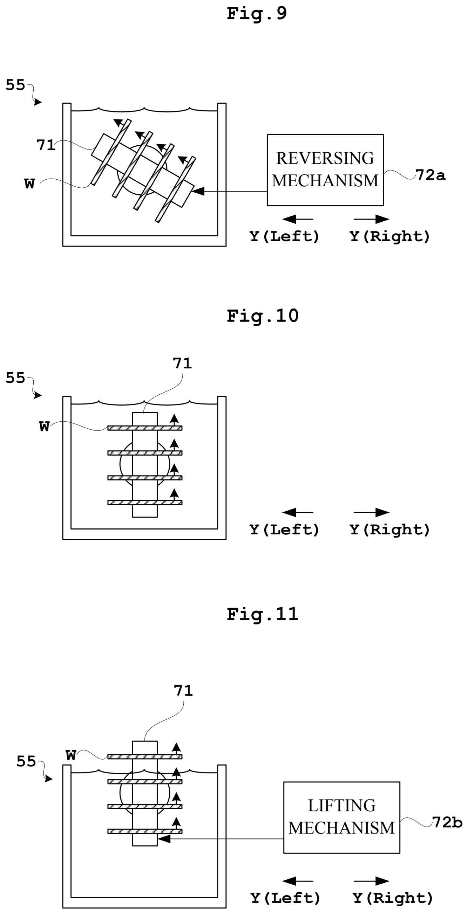

FIG. 9 illustrates a state in which the reversing chucks 71 are then being rotated by 90° while the twenty-five substrates W are immersed in the pure water. The operation of the reversing chucks 71 is achieved by the reversing mechanism 72a of the reversing chuck supporting mechanisms 72. FIG. 10 illustrates a state after the reversing chucks 71 have been rotated by 90°. In this manner, the device surfaces of the twenty-five substrates W immersed in the standby bath 55, the device surfaces having been facing the Y direction (leftward), are rotated by 90° and face upward. When the substrates W are tilted in this manner, it is possible to set the orientation of the substrates W to the horizontal orientation, in a manner having device surfaces facing upward. Thereafter, the substrates W in the horizontal orientation are transported with the device surfaces thereof facing upward.

FIG. 11 illustrates a state after the reversing chucks 71 then move one of the twenty-five substrates W above the liquid level of the standby bath 55. This operation of the reversing chucks 71 is achieved by the lifting mechanism 72b in the reversing chuck supporting mechanisms 72. In FIG. 11, there is only one substrate W above the liquid level, and the remaining twenty-four substrates W are under the liquid level in the standby bath 55. With such a configuration, the twenty-four substrates W do not get dry while waiting to be transported. The one substrate W above the liquid level is then transported to the single-wafer processing chamber 48 by the center robot CR, while being maintained in the horizontal orientation, with a puddle of pure water sitting on the top surface. By repeating this operation, all of the twenty-five substrates W are transported to the single-wafer processing chamber 48 by the center robot CR.

As described above, the lifting mechanism 72b according to the present example is configured to perform the exposing operation of bringing each of the substrates W kept on standby in the standby bath 55 above the standby bath 55, one by one.

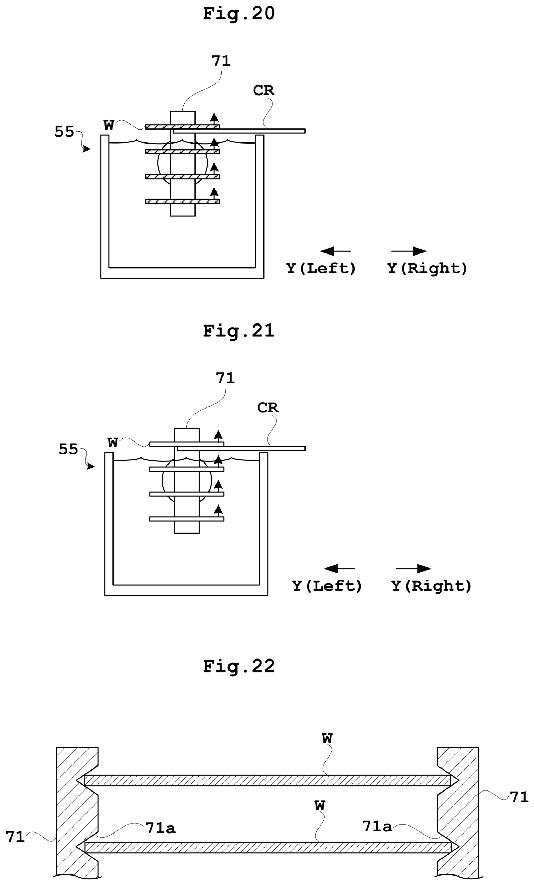

The operations of opening and closing the reversing chucks 71 in each of the states illustrated in FIGS. 4 to 11, respectively, will now be explained. As described above, the pair of reversing chucks 71 in the states illustrated in FIGS. 4 to 6 is in the open state, and is not in a state where the reversing chucks 71 can hold the substrates W. Because the reversing chucks 71 in the open state can pass by the substrates W, the reversing chucks 71 can move to the position illustrated in FIG. 6B without colliding with the substrates W. In FIG. 7, the pair of reversing chucks 71 in the open state is switched to the closed state. At this time, ends of the twenty-five substrates W arranged at the full pitches go into and abut against the respective V-shaped grooves that are provided on the pair of reversing chucks 71. Because the V-shaped grooves are arranged at the full pitches, the twenty-five substrates W arranged at the full pitches can easily fit into the respective V-shaped grooves. A detailed description as to how the substrates W fit into the respective V-shaped grooves will be given with reference to FIG. 22. The pair of reversing chucks 71 in FIGS. 8 to 10 is in the closed state, and is gripping the substrates W. Even if the reversing chucks 71 are rotated in this state, the substrates W being gripped by the reversing chucks 71 do not fall off.

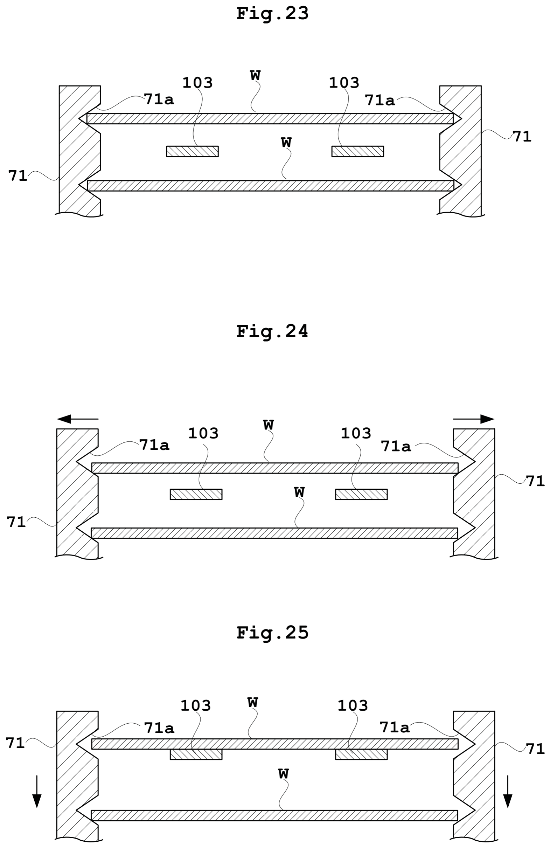

In order to achieve the state illustrated in FIG. 11, some kind of devising is necessary to prevent the substrates W kept on standby in the standby bath 55 from falling off, while allowing the substrates W to be transported to the center robot CR. Therefore, according to the present embodiment, the pair of reversing chucks 71 is half-opened, in the state illustrated in FIG. 11. In this manner, a state where the substrates W are supported removably is achieved. This half-opened state will be described in detail with reference to FIGS. 24 and 25.

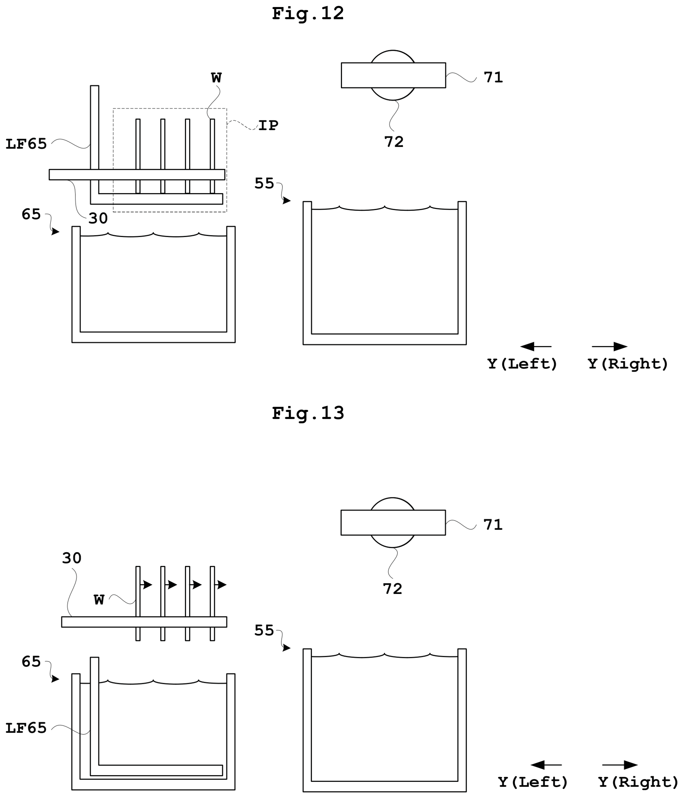

FIG. 12 illustrates a state in which the lifter LF65 then holds a plurality of substrates W at the midair position set above the backup bath 65. The substrate transport mechanism WTR is responsible for the transportation of the substrates to the midair position. The twenty-five substrates W placed on the lifter LF65 are arranged at the full pitches, with the device surfaces thereof facing rightward. These substrates W are the substrates W having been left out in the backup bath 65 in FIG. 5. A description as to how these twenty-five substrates W are transported will now be given with reference to FIG. 12. FIG. 12 illustrates a state after the transportation of the substrates in the horizontal orientation, described in FIG. 11, is finished, and the pair of reversing chucks 71 is returned to the initial state illustrated in FIG. 4. The pair of reversing chucks 71 in the initial state extends in the Y direction and is enabled to receive substrates W in the vertical orientation, and is located above the standby bath 55.

FIG. 13 is a diagram corresponding to FIG. 5 described above, and illustrates a state in which twenty-five substrates W have been passed to the chucks 30 of the auxiliary robot STR. FIG. 14 is a diagram corresponding to FIG. 6 described above, and illustrates a state in which the auxiliary robot STR moves the twenty-five substrates W to a position between the standby bath 55 and the pair of reversing chucks 71. FIG. 15 is a schematic corresponding to FIG. 7 described above, and illustrates a state in which twenty-five substrates W are passed from the auxiliary robot STR to the pair of reversing chucks 71. FIG. 16 is a schematic corresponding to FIG. 8 described above, and illustrates a state in which the twenty-five substrates W supported by the pair of reversing chucks 71 are positioned above the standby bath 55.

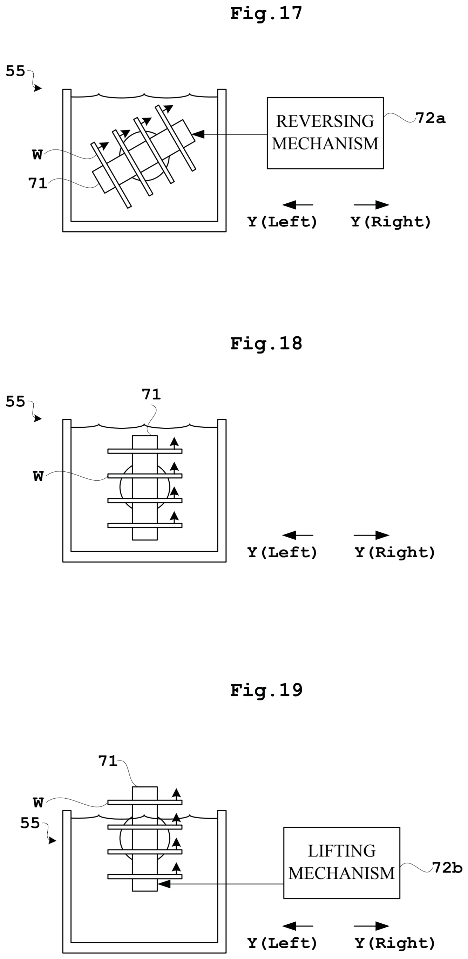

FIG. 17 illustrates a state in which the reversing chucks 71 are then being rotated by -90° while the twenty-five substrates W are immersed in the pure water. The operation of the reversing chucks 71 is achieved by the reversing mechanism 72a of the reversing chuck supporting mechanisms 72. FIG. 18 illustrates a state after the reversing chucks 71 have been rotated by -90°. In this manner, the device surfaces of the twenty-five substrates W immersed in the standby bath 55, the device surfaces having been facing the Y direction (rightward), are rotated by 90° and face upward. When the substrates W are tilted in this manner, it is possible to set the orientation of the substrates W to the horizontal orientation, in a manner having device surfaces facing upward. Thereafter, the substrates W in the horizontal orientation are transported with the device surfaces thereof facing upward.

FIG. 19 is a diagram corresponding to FIG. 11 described above, and illustrates a state in which only the uppermost substrate W is exposed above the liquid level of the standby bath 55, while the pair of reversing chucks 71 is in the half-opened state. Such a movement of the substrate W is achieved by the lifting mechanism 72b of the reversing chuck supporting mechanisms 72. The lifting mechanism 72b raises the pair of reversing chucks 71 by the height corresponding to one full pitch. By repeating this operation, all of the twenty-five substrates W are transported to the single-wafer processing chamber 48 by the center robot CR.

FIG. 20 illustrates the state in which the center robot CR is picking up the horizontally orientated substrate W above the standby bath 55. The hand 103 of the center robot CR can access the space above the standby bath 55, and can pick up the substrate W being held by the reversing chucks 71. FIG. 20 illustrates the state in which the center robot CR is picking up the first substrate W1 illustrated in FIG. 11. Similarly, FIG. 21 illustrates the state in which the center robot CR is picking up the second substrate W2 illustrated in FIG. 19. The center robot CR can carry the substrate W positioned above the standby bath 55 to the outside.

The half-opened state of the pair of reversing chucks 71 will now be explained. FIG. 22 is a cross-sectional view illustrating a state immediately after the twenty-five substrates W are rotated by 90° or -90°, as illustrated in FIGS. 10 and 18. The pair of reversing chucks 71 at this time is in the closed state, and both ends of the substrates W are at the deepest positions of the V-shaped grooves 71a. By causing the pair of reversing chucks 71 to press both ends of the substrates W and to fix the substrates W, in the manner described above, the twenty-five substrates W are prevented from sliding off from the pair of reversing chucks 71. In FIG. 22 and subsequent FIGS. 23 to 25, the liquid level in the standby bath 55 is omitted.

FIG. 23 is a cross-sectional view corresponding to FIGS. 20 and 21 described above. The pair of reversing chucks 71 is in the closed state, and the hand 103 of the center robot CR is inserted between the substrates W.

FIG. 24 illustrates a state where the pair of reversing chucks 71 in the closed state is slightly separated from each other to achieve the half-opened state. When the pair of reversing chucks 71 is in the half-opened state, both ends of the substrates W move from the deepest portions of the V-shaped grooves, and come into abutment against the walls of the V-shaped grooves. In this state, the substrates W do not slide off the reversing chucks 71 unless the reversing chucks 71 are rotated, and the substrates W themselves are not fixed to the reversing chucks 71, either. Therefore, when the pair of reversing chucks 71 is in the half-opened state, it is possible to pass one of the substrates W to the hand 103 above the liquid level, while holding the substrates W kept on standby in the liquid. Such an operation of the reversing chucks 71 is executed by the opening/closing mechanism 72c.

However, in the state illustrated in FIG. 24, because the hand 103 has not come into abutment on the substrate W yet, in order to pass the substrate W to the hand 103, it is necessary to lower the substrate W with respect to the hand 103.

FIG. 25 is also a cross-sectional view corresponding to FIGS. 20 and 21 described above. In FIG. 25, the pair of reversing chucks 71 is lowered slightly from the state illustrated in FIG. 24 so as to bring the substrate W into abutment on the hand 103. In the state illustrated in FIG. 25, the substrate W is placed on the hand 103, and is at a position away from the wall surfaces of the V-shaped grooves 71a of the reversing chucks 71. That is, in the state illustrated in FIG. 25, the substrate W is not in contact with the reversing chucks 71. Therefore, by pulling out the hand 103 in this state, the substrate W is pulled out from the space above the standby bath 55, without abutting against the reversing chucks 71.

Note that FIG. 25 illustrates a configuration in which the pair of reversing chucks 71 passes the substrate W to the hand 103 by being lowered with respect to the hand 103. However, without limitation to such a specific example, the substrate W can be passed as long as the positional relationship between the reversing chucks 71 and the hand 103 in the Z direction changes relatively. For example, even with a configuration in which the hand 103 rises from the state illustrated in FIG. 24 slightly with respect to the pair of reversing chucks 71, the substrate W can be passed similarly to the configuration described with reference to FIG. 25.

### <12. Single-Wafer Transport Block>

The single-wafer transport block 4 will now be explained with reference to FIG. 1. The single-wafer transport block 4 has an elongated shape extending in the X direction. The single-wafer transport block 4 includes a pass box 24, a center robot CR, and a guide rail 41X extending in the X direction for moving the center robot CR in the X direction. In the pass box 24, the substrates W in the horizontal orientation can be disposed in a manner stacked on top of one another. The center robot CR can be reciprocated by being guided along the guide rail 41X.

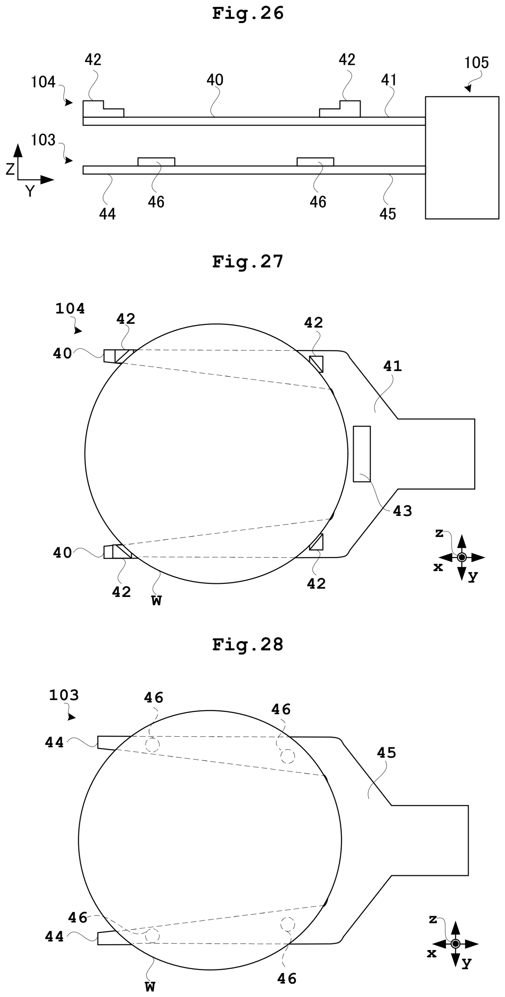

The center robot CR includes the hand 103 and a hand 104 for transporting the substrate W. FIG. 26 illustrates a configuration of the center robot CR according to the present invention. The center robot CR includes the hand 103 for transporting a wet substrate, the hand 104 for transporting a dry substrate, and a robot base 105 that supports the hand 103 and the hand 104. The hand 104 and the hand 103 are stacked in the Z direction, and the hand 104 is positioned above the hand 103.

The hand 103 is a wet hand for carrying a substrate W above the standby bath 55 into the single-wafer processing chamber 48. The hand 104 is a dry hand for carrying the substrate W having been dried, from the single-wafer processing chamber 48.

FIG. 27 illustrates a configuration of the hand 104 involved in transporting a dry substrate, according to this example. The hand 104 according to this example has two blades 40 and a base member 41 connected to the base ends of the respective blades 40. Guides 42 coming into abutment against the substrate W are provided to the tip end and the base end of each of the blades 40, and the hand 104 supports the substrate W using the guides 42. The guide 42 has a wall portion abutting against the bevel portion of the substrate W.

A pusher 43 is disposed on the base member 41, and can move in the direction in which the blades 40 extend. When the pusher 43 moves toward the tip of the blades 40, the pusher 43 comes into abutment against an end of the substrate W. The bevel portion of the substrate W then abuts against the wall portion of the guide 42 that is provided to the tip end of the blade 40. In this manner, the substrate W is held by the hand 104 by being nipped between the wall portion of the guide 42 and the pusher 43. Note that FIG. 27 illustrates a state in which the pusher 43 is positioned away from the tip end of the blade 40, and the substrate W is not yet held by the hand 104.

FIG. 28 illustrates a configuration of the hand 103 involved in the transportation of a wet substrate, according to this example. The hand 103 according to this example also has two blades 44 and a base member 45 connected to the base ends of the respective blades 44. Pins 46 coming into abutment against the bottom of the substrate W are provided to the tip end and the base end of each of the blades 44, and the hand 103 supports the substrate W from the bottom, using the pins 46. Because the pins 46 do not come into abutment against the bevel portion of the substrate W, liquid does not drip from the bevel portion of the substrate W even if the hand 103 transports the substrate W having a puddle of liquid on the surface.

The center robot CR includes the robot base 105 that supports the hand 104 and the hand 103. The center robot CR can move the hand 104 and the hand 103 independently in the horizontal direction (Y direction in FIG. 26), with respect to the robot base 105. In addition, the center robot CR can direct both of the hand 104 and the hand 103 simultaneously at least rightward, leftward, or frontward. The center robot CR can also move the hand 104 and the hand 103 up or down, at once.

With such a configuration, the center robot CR can access the space above the standby bath 55 in the orientation conversion block 6. At this time, the center robot CR directs the hand 103 leftward, and raises the hand 103 to the midair position above the standby bath 55.

The hand 103 of the center robot CR can access the single-wafer processing chambers 48 in the single-wafer processing block 8, to be described later. At this time, the center robot CR directs the hand 103 rightward, and raises the hand 103 to a target single-wafer processing chamber 48. Referring to FIG. 1, the single-wafer processing block 8 includes a front single-wafer processing chamber 48 and a rear single-wafer processing chamber 48. When the center robot CR accesses the front single-wafer processing chamber 48, the center robot CR is brought to the front side, by following the guidance of the guide rail 41X. When the center robot CR accesses the rear single-wafer processing chamber 48, the center robot CR is brought to the rear side, by following the guidance of the guide rail 41X.

The hand 104 of the center robot CR can also access the single-wafer processing chamber 48 in the single-wafer processing block 8. At this time, the center robot CR directs the hand 104 rightward, and raises the hand 104 to a target single-wafer processing chamber 48. The center robot CR can access the front single-wafer processing chamber 48 and the rear single-wafer processing chamber 48 by reciprocating by following the guidance of the guide rail 41X, in the same manner as the hand 103 described above.

The hand 104 of the center robot CR can also access the pass box 24. At this time, the center robot CR directs the hand 104 forward, and raises the hand 104 to the pass box 24.

A reference position BP of the center robot CR is established in the single-wafer transport block 4. When the center robot CR is at the head position in the X direction, the center robot CR is at the reference position BP. The center robot CR at the reference position BP can access any of the standby bath 55 in the orientation conversion block 6, the single-wafer processing chamber 48 in the single-wafer processing block 8, and the pass box 24 in the single-wafer transport block 4. The single-wafer processing chamber 48 includes two chambers, one of which is located at the reference position BP and the other of which is located on the rear side of the reference position BP. Among these two, the center robot CR at the reference position BP can access the single-wafer processing chamber 48 at the reference position BP. When the center robot CR accesses the single-wafer processing chamber 48 on the rear side, the center robot CR moves backward from the reference position BP. The guide rail 41X is used for this movement.

The reference position BP is at a position adjacent to the standby bath 55 in the Y direction. The Y direction corresponds to the horizontal direction according to the present invention. The reference position BP is at a position adjacent to the pass box 24 in the X direction. Therefore, the reference position BP is located on the right side of the standby bath 55 and on the rear side of the pass box 24. The reference position BP is the front limit by which the center robot CR can move in the X direction. The center robot CR having moved to the foremost position is at the reference position BP.

The center robot CR carries the substrate W collected from above the standby bath 55 into the single-wafer processing chamber 48. At the time of carrying the substrate W from the standby bath 55, the center robot CR is at the reference position BP. At the time of carrying the substrate W to the single-wafer processing chamber 48, the center robot CR is at the reference position BP or on the rear side of the reference position BP.

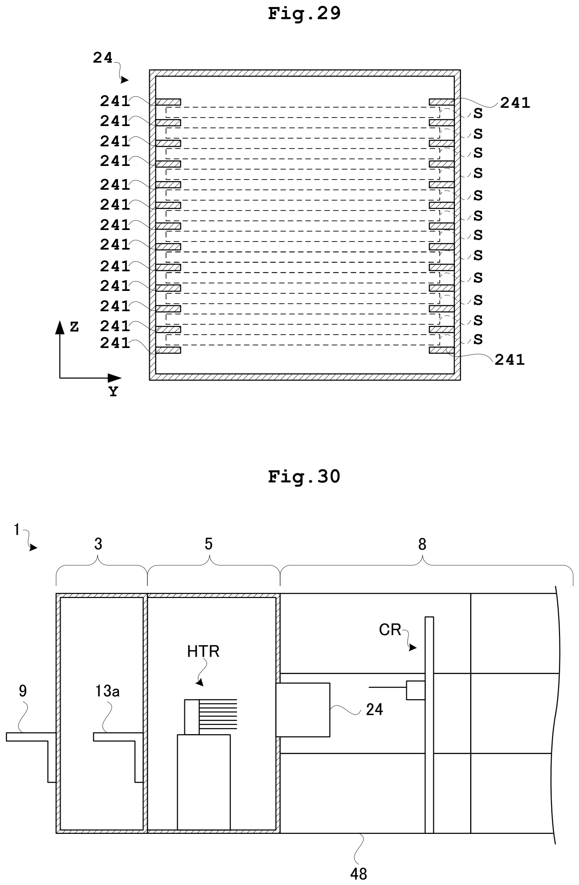

FIG. 29 illustrates the pass box 24 according to this example. The pass box 24 includes a pair of comb-shaped members 241 that supports a stack of the substrates W in the horizontal orientation. The pair of comb-shaped members 241 is provided on the respective inner walls of the side surfaces of the box-shaped pass box 24, and is configured to support a substrate W by coming into abutment against one end and the other end of the substrate W. The pair of comb-shaped members 241 forms a plurality of slots S, and, in each of the slots S, one substrate is housed. The pass box 24 can hold twenty-five substrates W in the respective slots S. At this time, the substrates W are arranged at the full pitches (1 cm intervals).

The pass box 24 is a temporary place where the center robot CR stacks and places substrates having been subjected to single-wafer process, and corresponds to a substrate placing unit according to the present invention. The center robot CR is enabled to move the hand 103, 104 in the Z direction so that the substrate W can be placed in any one of the slots S formed by the comb-shaped member 241.

FIG. 30 is an apparatus side view for explaining the position of the pass box 24. As illustrated in this drawing, the pass box 24 is located in the middle layer of the substrate processing apparatus 1. Specifically, the pass box 24 is at a height where the handling robot HTR can access.

### <13. Single-Wafer Processing Block>

The single-wafer processing block 8 includes the plurality of single-wafer processing chambers 48 for processing each one of the substrates W in the horizontal orientation. That is, the single-wafer processing block 8 has a stack of the single-wafer processing chambers 48. In the substrate processing apparatus 1 according to this example, two stacks are arranged in the front-back direction. In the single-wafer processing block 8, the single-wafer processing chambers 48 are arranged in the X direction.

The center robot CR is enabled to move the hand 103, 104 in the Z direction so that the center robot CR can access any of the single-wafer processing chambers 48 included in the stacks.

A spin chuck is provided in each of the single-wafer processing chambers 48. The spin chuck is enabled to rotate while holding a substrate W. When the center robot CR has placed the substrate W being held thereby on the spin chuck, the center robot CR finishes loading the substrate W into the single-wafer processing chamber 48. The center robot CR finishes unloading a substrate W from the single-wafer processing chamber 48 upon receiving the substrate W placed on the spin chuck from the spin chuck.

The single-wafer processing chamber 48 can dry the substrate W by spin drying. The hand 103 of the center robot CR carries a substrate W having a puddle of pure water on the surface, into the single-wafer processing chamber 48. The hand 104 of the center robot CR takes out the substrate W having been dried through spin drying, from the single-wafer processing chamber 48.

The single-wafer processing chamber 48 has a predetermined length in the X direction. The center robot CR is movable at least by a predetermined length in the X direction from the reference position BP. With this configuration, the center robot CR can access the single-wafer processing chamber 48 located on the rear side of the reference position BP.

### <14. Maintenance Area>

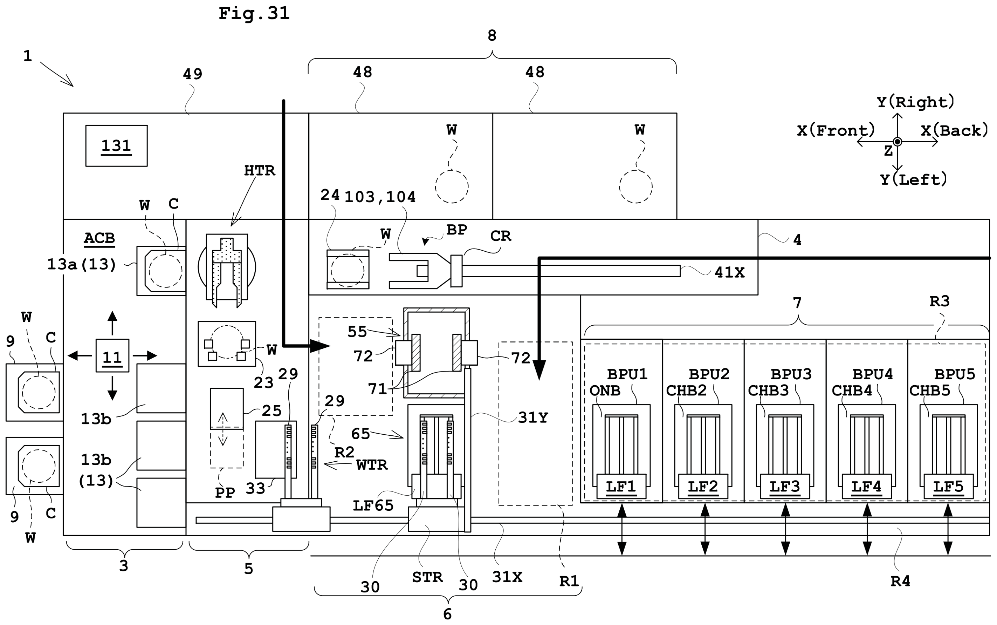

As illustrated in FIG. 31, the substrate processing apparatus 1 according to this example includes two maintenance areas R1, R2. The maintenance areas R1, R2 are areas that an operator enters when the operator performs maintenance of the substrate processing apparatus 1. The baths such as the standby bath 55 and the devices such as the HVC orientation converting unit 23 are provided in a manner avoiding the maintenance areas R1, R2.

The first maintenance area R1 is located inside the orientation conversion block 6, and is at a position between the array including the backup bath 65 and the standby bath 55, and the batch processing block 7. The first maintenance area R1 is, for example, an area where an operator enters when the operator performs maintenance of the center robot CR. The first maintenance area R1 extends in a direction moving away from the single-wafer processing block 8 with respect to a first passage to be described later, and corresponds to a first room according to the present invention.

For the operator to enter the first maintenance area R1, the operator first enters the single-wafer transport block 4, and moves forward. When the operator changes the traveling direction from there to the left, the operator arrives at the first maintenance area R1. The single-wafer processing block 8 is the first passage that is adjacent to the batch processing block 7 in the Y direction, and that is accessible to the center robot CR.

The second maintenance area R2 is located inside the orientation conversion block 6, and is at a position between the backup bath 65 and the transfer block 5. The second maintenance area R2 is, for example, an area where an operator enters when the operator performs maintenance of the backup bath 65, the reversing chucks 71, and the reversing chuck supporting mechanisms 72. The second maintenance area R2 extends in a direction moving closer to the standby bath 55 from a second passage to be described later, and corresponds to a second room according to the present invention.

For the operator to enter the second maintenance area R2, the operator first moves along a passage extending from the front side of the single-wafer processing block 8 in the Y direction. After having passed behind the handling robots HTR and HVC orientation converting unit 23, the operator arrives at the second maintenance area R2. The transfer block 5 has the second passage adjacent to the handling robot HTR and extending in the Y direction.

### <15. Other Configurations>

As illustrated in FIG. 1, a control area 49 including a control unit related to the control of the apparatus is provided in front of the single-wafer processing block 8. In the control area 49, a control unit 131 related to the control of the substrate processing apparatus 1 is provided. Although not illustrated in FIG. 1, the substrate processing apparatus 1 includes a storage unit corresponding to the control unit 131. The control unit 131 is implemented as a central processing unit (CPU), for example. There is no limitation to a specific configuration of the control unit, and the control units may be implemented as a single processor, or each of the control units may be implemented as individual processors, for example.

Examples of the control related to the control unit 131 include control related to the carrier transport mechanism 11, the handling robot HTR, the HVC orientation converting unit 23, the pusher mechanism 25, the substrate transport mechanism WTR, the batch processing units BPU1 to BPU5, and control related to the center robot CR, the single-wafer processing chambers 48, the reversing chucks 71, and the auxiliary robot STR.

That is, the control unit 131 controls the center robot CR to receive the substrate W having a puddle of pure water on the surface, using the hand 103, and to transport the substrate W into the single-wafer processing chamber 48. The control unit 131 controls the center robot CR to receive the substrate having been dried in the single-wafer processing chamber 48, using the hand 104, and transport the substrate to the pass box 24. The control unit 131 then controls the handling robot HTR to return the substrate W having been dried, to the carrier C.

The storage unit stores therein a program, a parameter, and the like related to the control. The storage unit may be configured as a single device, or may be configured as independent devices corresponding to the respective control units. Furthermore, the substrate processing apparatus 1 according to this embodiment is not limited by any particular configuration of the device implementing the storage unit.

### <16. Sequence of Substrate Processing>

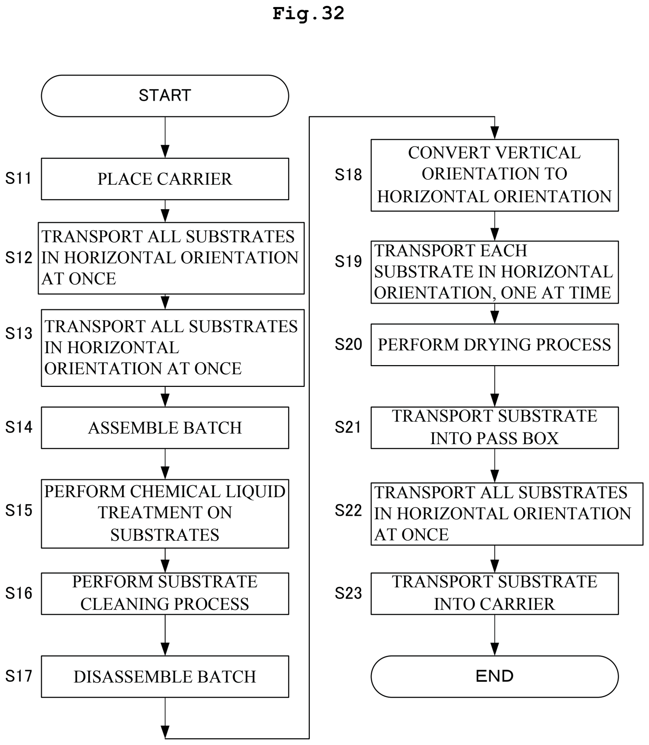

The sequence of the substrate processing that uses the substrate processing apparatus 1 according to this example will now be described with reference to FIG. 32. FIG. 32 is a flowchart explaining the operation of the substrate processing apparatus according to this example. Each step of the flowchart will now be explained.

Step S11: The carrier C storing therein unprocessed substrates W is placed on the loading port 9. The carrier transport mechanism 11 then transports the carrier C to the carrier retainer shelf 13a.

Step S12: The handling mechanism HTR takes out the substrates W stored in the carrier C, all at once, and transports the substrates W to the HVC orientation converting unit 23.

Step S13: The HVC orientation converting unit 23 picks up the substrates W in the horizontal orientation, all at once, and converts the orientation of the substrates W from the horizontal orientation to the vertical orientation. The substrates W having the orientation converted are held by the pusher mechanism 25.

Step S14: The HVC orientation converting unit 23 assembles a batch of the substrates W by repeating changing the orientation of the substrates W and carrying the substrates W into the pusher mechanism 25. After the batch assembly, the pusher mechanism 25 holds the substrates W corresponding to two carriers C. The substrates W before being assembled into a batch are arranged at the full pitches (1 cm intervals), but the substrates W after having been assembled into a batch are arranged at the half pitches (5 mm intervals). As a result of this batch assembly, the substrates W form a lot in which the substrates W are in a face-to-face arrangement, for example.

Step S15: The substrate transport mechanism WTR receives the lot from the pusher mechanism 25, and transports the lot to the batch processing unit BPU5, for example. In the batch processing unit BPU5, the lot is subjected to the chemical liquid treatment (acid treatment). This step can also be carried out using any one of the batch processing units BPU2 to BPU4, instead of the batch processing unit BPU5.

Step S16: The substrate transport mechanism WTR then transports the lot for which the chemical liquid treatment has been finished, to the batch processing unit BPU1. In the batch processing unit BPU1, the lot is subjected to the cleaning process. The substrate transport mechanism WTR then transports the lot for which the cleaning process has been finished, to the backup bath 65.

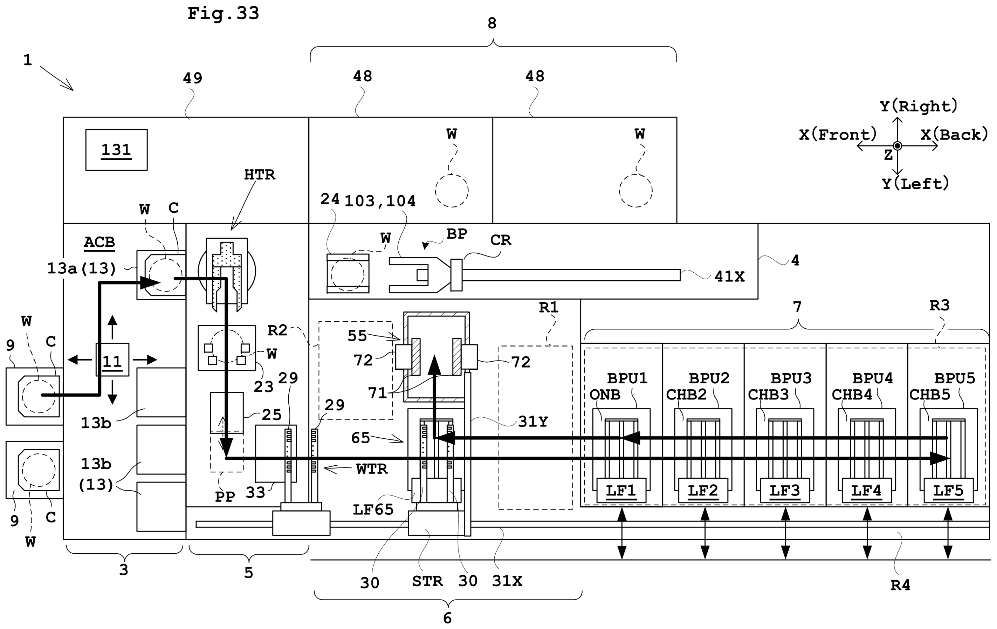

Step S17: The auxiliary robot STR selects and holds a group of substrates that are arranged at the full pitches from the lot immersed in the backup bath 65, and disassembles the lot. The auxiliary robot STR transports the substrate group having been held thereby to the standby bath 55. FIG. 33 illustrates how the substrates are transported between step S11 and step S17. In other words, between step S11 and step S17, the substrates W go through the loading port 9, the carrier retainer shelf 13a, the handling robot HTR, the HVC orientation converting unit 23, the pusher mechanism 25, the substrate transport mechanism WTR, the batch processing unit BPU5, the batch processing unit BPU1, the backup bath 65, and the auxiliary robot STR, and reach the standby bath 55.

Step S18: The reversing chucks 71 then convert the vertically orientated substrates W conveyed to the standby bath 55 to the horizontal orientation.

Step S19: The center robot CR picks up the horizontally orientated substrate W located above the standby bath 55, and transports the substrate W into the single-wafer processing chamber 48 in the single-wafer processing block 8. At this time, the center robot CR uses the hand 103 in transporting the substrate W.

Step S20: In the single-wafer processing chamber 48, the substrate W is dried by spin drying.

Step S21: The center robot CR receives the dried substrate W from the single-wafer processing chamber 48, and transports the substrate W into the pass box 24. At this time, the center robot CR uses the hand 104 in transporting the substrate W. Steps S19 to S21 are repeated until all of the substrates W are taken out of the standby bath 55. At this time, the center robot CR inserts each of the substrates W into corresponding one of the slots S in the pass box 24, and puts the substrates W into an arrangement along the Z direction inside the pass box 24.

Step S22: In this step, by repeating step S21, twenty-five substrates W are held in the pass box 24 in a manner arranged along the Z direction. The handling robot HTR acquires the horizontally oriented substrates W arranged as a stack in the pass box 24, all at once.

Step S23: The handling mechanism HTR stores the plurality of substrates having been held thereby in the empty carrier C placed on the carrier retainer shelf 13a. The carrier transport mechanism 11 then transports the carrier C on the carrier retainer shelf 13a to the loading port 9. In this manner, the substrate processing according to the present invention is ended.

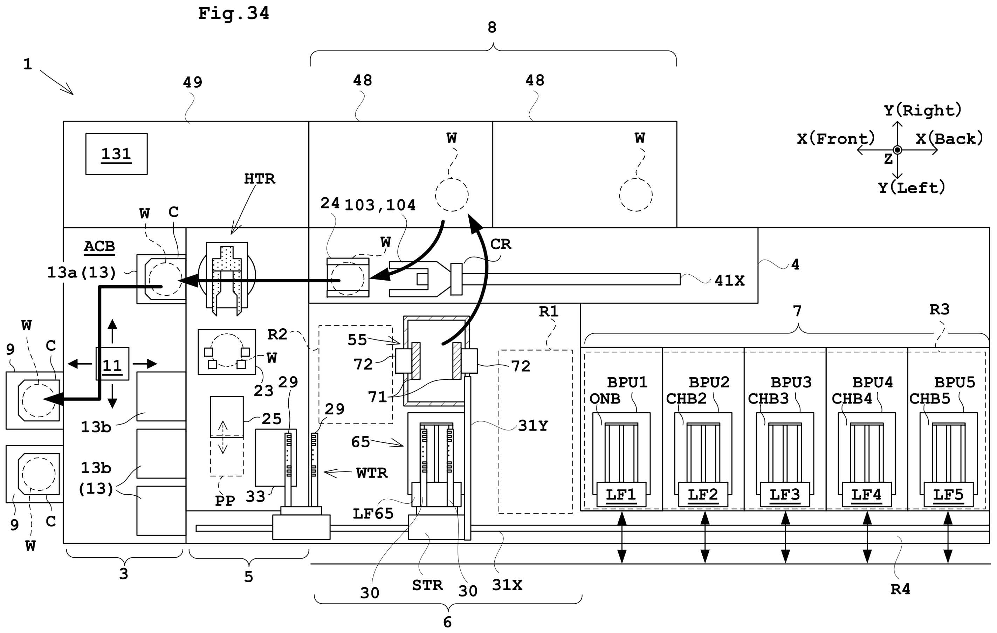

FIG. 34 illustrates how the substrates are transported between step S18 and step S23. In other words, the substrates W go through the standby bath 55, the center robot CR, the single-wafer processing chamber 48, the center robot CR, the pass box 24, the handling mechanism HTR, and the carrier retainer shelf 13a, and reach the loading port 9.

### <17. Effects Achieved by Present Invention>

With the configuration described above, the center robot CR transports the substrates from the space above the standby bath 55 to the single-wafer processing chamber 48. Therefore, the present invention does not need any device that conveys horizontally orientated substrates other than the center robot CR, as in the conventional configuration. According to the present invention, by omitting the substrate transport device that transfers a horizontally oriented substrate, it is possible to provide the substrate processing apparatus 1 with a smaller footprint.

The batch processing block 7 having the configuration described above is provided with the batch processing units BPU that are capable of immersing a plurality of vertically orientated substrates in the treatment liquid and are arranged in the X direction, and the substrate transport mechanism WTR that is capable of transporting the substrates having been processed by the batch processing units BPU, toward the standby bath 55 in the X direction, and the center robot CR is at the reference position BP spaced apart from the standby bath 55 in the Y direction that is orthogonal to the X direction. With this configuration, it is not necessary to separate the single-wafer processing block 8 and the batch processing block 7 in the X direction, and the length of the substrate processing apparatus in the X direction can be reduced.

With the configuration described above, the single-wafer processing block 8 includes the single-wafer processing chambers 48 that are arranged in the X direction; each of the single-wafer processing chambers 48 has a predetermined length in the X direction; and the center robot CR is enabled to move along the X direction by a distance equal to or more than the predetermined length from the reference position BP. With this configuration, the number of the single-wafer processing chambers 48 in the substrate processing block can be increased easily.

The configuration described above is provided with the backup bath 65 that receives the substrates having been transported toward the standby bath by the substrate transport mechanism WTR, and the auxiliary robot STR that transports the substrates between the backup bath 65 and the standby bath 55 in the Y direction. With this configuration, the substrates after the batch process can be transported reliably to the standby bath 55.

The configuration described above is provided with the handling robot HTR that picks up the substrates from a carrier C where the substrates in the horizontal orientation are stored as a stack, all at once. The handling robot HTR is enabled to pick up the substrates being stacked in the pass box 24, and store the substrates in the carrier C, all at once. With this configuration, because the unprocessed substrates and the processed substrates can be transported using the same robot, a substrate processing apparatus with a simple device configuration and a smaller footprint can be provided.

The configuration described above is provided with the carrier retainer shelf 13a on which the carrier C is placed; the standby bath 55 is at a position in the X direction from the carrier retainer shelf 13a; and the standby bath 55 is at a position in the direction opposite to the X direction from the batch processing block 7. With this configuration, because the standby bath 55 can be provided at the base end of the batch processing block 7, it is possible to provide a substrate processing apparatus having a smaller footprint.

With the configuration described above, the single-wafer processing chamber 48 performs a substrate drying process; and the center robot CR includes the hand 103 for carrying the substrate in the space above the standby bath 55 into the single-wafer processing chamber 48, and the hand 104 for carrying a substrate having been dried, out of the single-wafer processing chamber 48. With this configuration, the substrate having been subjected to the drying process can be reliably taken out from the single-wafer processing chamber 48.

The configuration described above is provided with the first passage adjacent to the batch processing block 7 from the Y direction, and accessible to the center robot CR; and the first maintenance area R1 extending from the first passage in a direction separating from the single-wafer processing block 8. With this configuration, it is possible to provide a substrate processing apparatus capable of performing maintenance of the center robot CR or the like, easily.

The configuration described above is provided with the second passage adjacent to the handling robot HTR and extending in the Y direction, and the second maintenance area R2 extending from the second passage in a direction approaching the standby bath 55. With this configuration, it is possible to provide a substrate processing apparatus capable of performing maintenance of the center robot CR or the like, easily.

### <18. Modifications>

The present invention is not limited to the configurations described above, and modifications such as those described below are still possible.

### <First Modification>

Although the single-wafer processing block 8 according to the embodiment described above includes the single-wafer processing chamber 48 capable of performing spin drying, it is also possible to use a single-wafer processing chamber 48 for forming a puddle on the substrate, and to provide a drying chamber 50 having a configuration different from that of the single-wafer processing chamber 48.

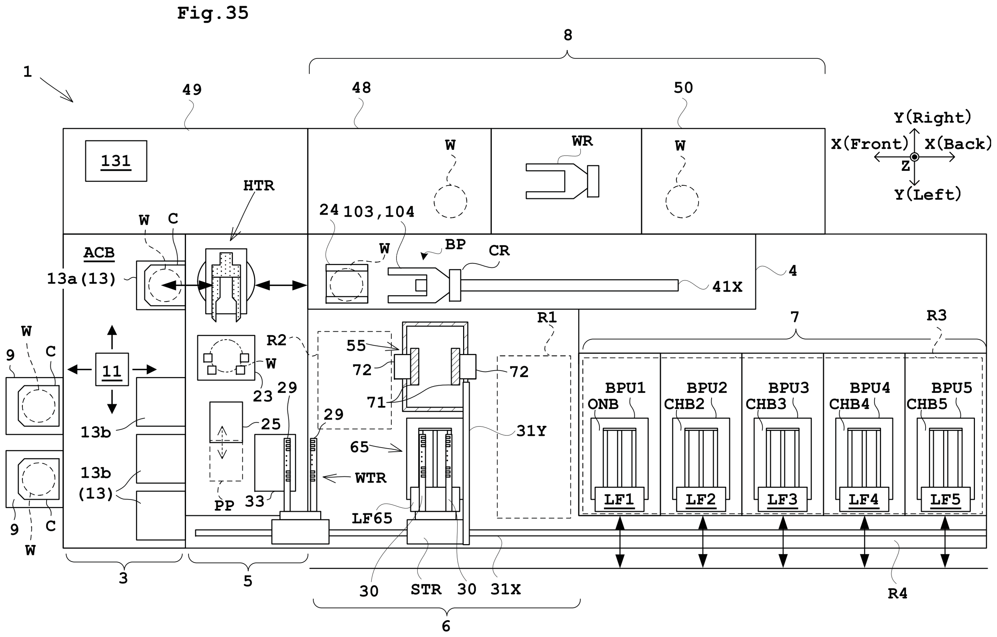

FIG. 35 illustrates a substrate processing apparatus according to this modification. As illustrated in FIG. 35, the substrate processing apparatus according to this modification is substantially the same as the substrate processing apparatus according to the embodiment, but there is a large difference in the configuration of the single-wafer processing block 8. The apparatus according to this modification includes a stack of the drying chambers 50, in addition to the stack of the single-wafer processing chambers 48. The apparatus according to this modification has a configuration in which the stack of the single-wafer processing chambers 48 is disposed on the front side, and the stack of the drying chambers 50 is disposed on the rear side.

Between the single-wafer processing chambers 48 and the drying chambers 50, a wet robot WR for transporting the substrate W having a puddle of liquid on the surface is provided. The wet robot WR transports the substrate W having a puddle of liquid formed in the single-wafer processing chamber 48 to the drying chamber 50 while maintaining the puddle.

The single-wafer processing chamber 48 forms a puddle of organic solvent on the received substrate W. The organic solvent may be, for example, IPA. Because the substrate W having a puddle of pure water is carried into the single-wafer processing chamber 48 by the center robot CR, it can be said that the single-wafer processing chamber 48 has a function of replacing a puddle of the pure water with IPA, on the substrate W.

The drying chamber 50 is configured to perform a substrate drying process using a supercritical fluid. As the supercritical fluid, for example, carbon dioxide may be used.

The transportation of the substrate during the substrate processing according to this modification will now be explained. In this modification, substrates are acquired from the carrier C, are subjected to a predetermined process, and the processed substrates are returned to the carrier C, in the same manner as in the embodiment. The substrates W stored in the carrier C are transported from the transfer block 5, through the batch processing block 7, and to the standby bath 55 in the orientation conversion block 6. This transportation is the same as that in the embodiment, and it is possible to refer to FIG. 33 for the substrate transportation during this period.

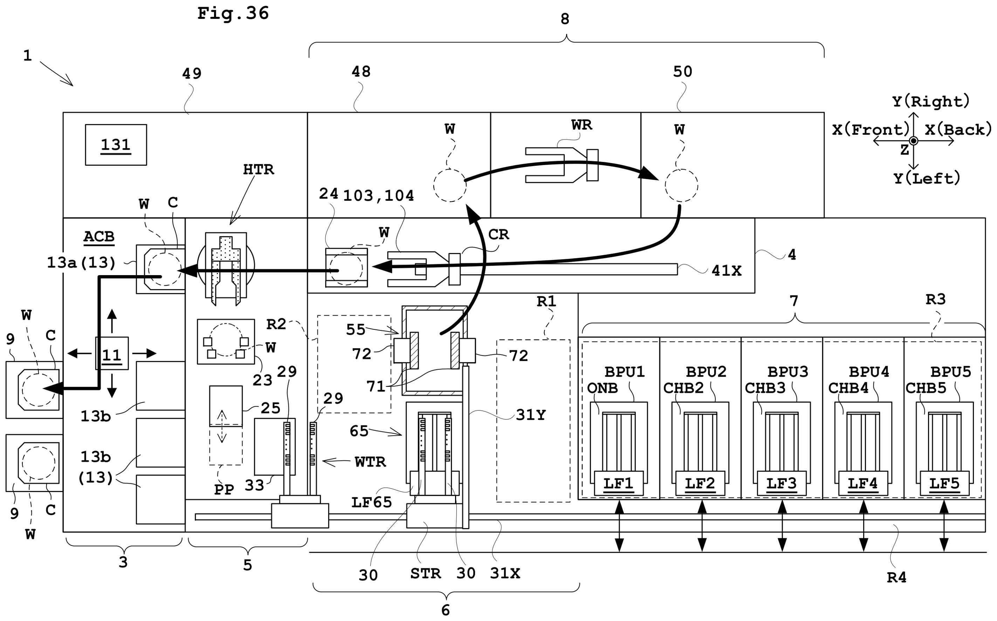

FIG. 36 illustrates the state in which a horizontally orientated substrate W kept on standby in the standby bath 55 is put through the drying process, and returned to the carrier C. The substrate W with a puddle of pure water is transported from the standby bath 55 to the single-wafer processing chamber 48. This transportation of the substrate W is achieved by the center robot CR, with the use of the hand 103.

The substrate W carried into the single-wafer processing chamber 48 is rotated by a spin chuck mounted on the single-wafer processing chamber 48, and pure water on the substrate W is thus removed. After the substrate W stops being rotated, the single-wafer processing chamber 48 supplies the IPA to the substrate W, using a nozzle attached thereto, to form a puddle on the substrate W.

The wet robot WR then receives the substrate W with a puddle of IPA, and transports the substrate W into the drying chamber.

In the drying chamber, the substrate W is dried using a supercritical fluid.

The center robot CR then transports the substrate W having been subjected to the drying process to the pass box 24, by using the hand 104. Subsequently, the substrate is transported in the same manner as in the embodiment. In this regard, FIG. 34 may be referred to.

As described above, with the configuration according to this modification, the wet robot WR for taking out the substrate W having a puddle formed on the surface in the single-wafer processing chamber 48, and transporting the substrate into the drying chamber 50 is provided between the single-wafer processing chamber 48 (first single-wafer processing chamber) and the drying chamber 50 (second single-wafer processing chamber) that are spaced apart from each other in the X direction. With this configuration, the wet robot WR and the center robot CR can operate independently without interfering with each other.

With the configuration according to this modification, the single-wafer processing chamber 48 is located closer to the reference position BP of the center robot CR than the drying chamber 50. With this configuration, when the center robot CR moves a wet substrate W from above the standby bath 55 to the first single-wafer processing chamber 48, the distance by which the substrate W is moved can be minimized. Therefore, it is possible to provide the substrate processing apparatus 1 in which the center robot CR can transport a substrate W while keeping the wet state thereof, reliably.

With the configuration according to this modification, the drying chamber 50 performs a drying process using a supercritical fluid. As described above, the present invention is suitable for a substrate processing apparatus that uses a supercritical fluid.

### <Second Modification>

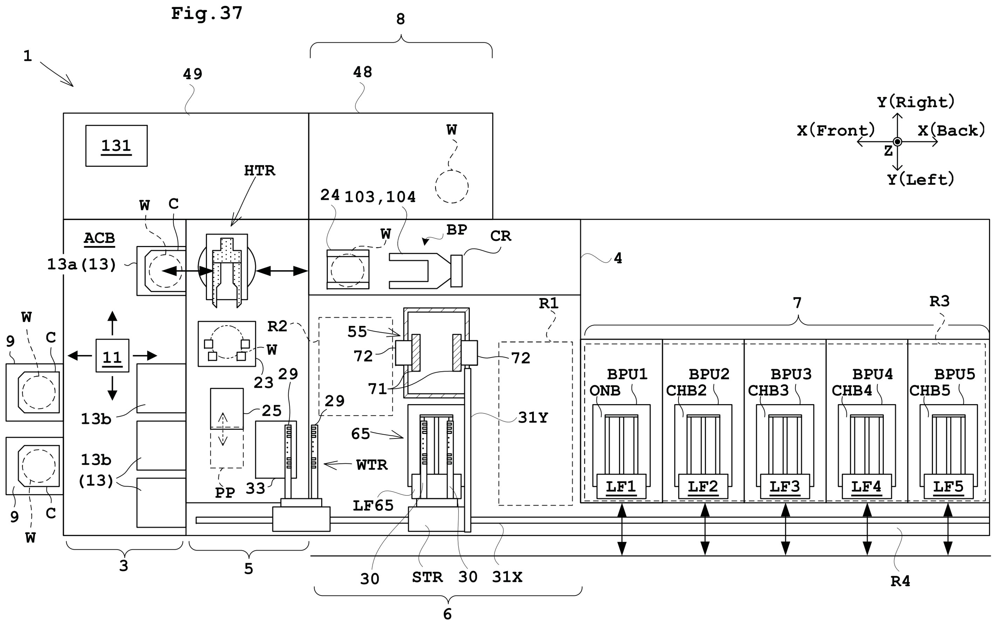

In the substrate processing apparatus 1 according to the embodiment, the single-wafer processing block 8 is provided with the reference position BP for the center robot CR, and the two stacks of the single-wafer processing chambers 48 that are provided at the reference position BP and a position on the rear side of the reference position BP, respectively, but the present invention is not limited to this configuration. As illustrated in FIG. 37, the number of the stacks of single-wafer processing chambers 48 may be one. Furthermore, the substrate processing apparatus 1 according to the present invention may include three or more stacks of the single-wafer processing chambers 48. In such a case, three or more stacks are arranged along the X direction in the single-wafer processing block 8. As described above, the substrate processing apparatus 1 according to the present invention can increase or decrease the number of the stacks, on the basis of the purpose of substrate processing.

Note that the guide rail 41X illustrated in FIG. 1 is not necessarily required in the configuration in which there is one stack of the single-wafer processing chambers 48, as illustrated in FIG. 37. That is, the substrate processing apparatus 1 according to this modification still holds even without the configuration for moving the center robot CR from the reference position BP in the X direction.

## Claims

1. A substrate processing apparatus that performs a batch process for processing a plurality of substrates all at once, and a single-wafer process for processing one of the substrates at a time, continuously, the substrate processing apparatus comprising:
a batch processing block (7) that performs the batch process;
a first orientation conversion mechanism (71) capable of converting the plurality of substrates having been subjected to the batch process, from a vertical orientation to a horizontal orientation;
a standby bath (55) where the plurality of substrates having been converted into the horizontal orientation are kept on standby;
a lifting mechanism (LF65) that performs an exposing operation of bringing one of the substrates kept on standby in the standby bath (55), the one being one substrate at a time, to a space above the standby bath (55);
a center robot (CR) capable of carrying the substrates in the space above the standby bath (55) to outside; and
a single-wafer processing block (8) including a single-wafer processing chamber (48) where the single-wafer process is performed to the substrates in the horizontal orientation,
wherein the center robot carries the substrates having been moved out of the space above the standby bath (55) into the single-wafer processing chamber (48).

2. The substrate processing apparatus according to claim 1, wherein
the batch processing block (7) includes: treatment baths arranged along a predetermined direction and allowing a plurality of vertically oriented substrates to be immersed in a treatment liquid; and
a batch transport robot (WTR) capable of transporting the substrates having been subjected to treatment in the treatment bath, toward the standby bath (55) in the predetermined direction, and
the center robot (CR) is at a reference position that is spaced apart from the standby bath (55) in a horizontal direction that is orthogonal to the predetermined direction.

3. The substrate processing apparatus according to claim 2, wherein
the single-wafer processing block (8) includes a plurality of the single-wafer processing chambers (48) that are arranged in the predetermined direction,
each of the single-wafer processing chambers (48) has a predetermined length in the predetermined direction, and
the center robot (CR) is enabled to move along the predetermined direction by a distance equal to or more than the predetermined length from the reference position.

4. The substrate processing apparatus according to claim 3, further comprising, between a first substrate processing chamber (48) and a second substrate processing chamber (48) that are spaced apart from each other in the predetermined direction, a wet robot that carries a substrate on which a puddle is formed in the first substrate processing chamber (48) to outside, and transports the substrate into the second substrate processing chamber (50).

5. The substrate processing apparatus according to claim 4, wherein
the first substrate processing chamber (48) is at a position closer to the reference position than the second substrate processing chamber is.

6. The substrate processing apparatus according to claim 4, wherein
the second substrate processing chamber (50) performs a drying process using a supercritical fluid.

7. The substrate processing apparatus according to claim 2, further comprising:
a backup bath (65) that receives the substrates transported toward the standby bath (55) by the batch transport robot (WTR); and
an auxiliary robot(STR) that transports the substrates between the backup bath (65) and the standby bath (55) in the horizontal direction.

8. The substrate processing apparatus according to claim 2, further comprising:
a carrier robot (HTR) that picks up substrates from a carrier where the substrates in the horizontal orientation are stored as a stack, all at once;
a second orientation conversion mechanism (23) that converts the substrates in the horizontal orientation, the substrates having been picked up by the carrier robot (HTR), into the vertical orientation; and
a substrate placing unit (24) on which the center robot stacks and places the substrates having been subjected to the single-wafer process, wherein
the batch transport robot (WTR) is enabled to transport the substrates in the vertical orientation, the substrates being substrates having the orientation converted by the second orientation conversion mechanism (HTR), and
the carrier robot is enabled to pick up the substrates in the horizontal orientation, the substrates being stacked on the substrate placing unit (24), and to store the substrates in the carrier, all at once.

9. The substrate processing apparatus according to claim 8, further comprising a retainer shelf on which the carrier is placed, wherein
the standby bath (55) is at a position in the predetermined direction from the retainer shelf, and
the standby bath (55) is at a position in a direction opposite to the predetermined direction from the batch processing block (7).

10. The substrate processing apparatus according to claim 1, wherein
the single-wafer processing chamber (48) performs a substrate drying process; and
the center robot includes a wet hand for carrying a substrate in the space above the standby bath (55) into the single-wafer processing chamber (48), and a dry hand for carrying a substrate having been dried, out of the single-wafer processing chamber.

11. The substrate processing apparatus according to claim 1, further comprising
a first passage that is adjacent to the batch processing block (7) from the horizontal direction, and that is accessible to the center robot; and
a first room (R1) that extends from the first passage in a direction separating from the single-wafer processing block (8).

12. The substrate processing apparatus according to claim 8, comprising:
a second passage that is adjacent to the carrier robot and that extends in the horizontal direction, and
a second room (R2) that extends from the second passage in a direction approaching the standby bath (55).
